(19) Europäisches Patentamt
European Patent Office
Office européen des brevets

(11) **EP 2 849 348 B1**

(12) # EUROPEAN PATENT SPECIFICATION

(45) Date of publication and mention
of the grant of the patent:
**16.09.2020 Bulletin 2020/38**

(51) Int Cl.:
***H03M 7/30*** *(2006.01)*

(21) Application number: **13796618.0**

(22) Date of filing: **08.05.2013**

(86) International application number:
**PCT/CN2013/075315**

(87) International publication number:
**WO 2013/178009 (05.12.2013 Gazette 2013/49)**

(54) **SIGNAL RECONSTRUCTION METHOD AND DEVICE**

SIGNALREKONSTRUKTIONSVERFAHREN UND VORRICHTUNG

PROCÉDÉ ET DISPOSITIF DE RECONSTRUCTION DE SIGNAL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.05.2012 CN 201210174062**

(43) Date of publication of application:
**18.03.2015 Bulletin 2015/12**

(73) Proprietor: **Huawei Technologies Co., Ltd.
Longgang District
Shenzhen, Guangdong 518129 (CN)**

(72) Inventors:
• **ZHU, Hufei
Shenzhen
Guangdong 518129 (CN)**
• **YANG, Ganghua
Shenzhen
Guangdong 518129 (CN)**

(74) Representative: **Maiwald Patent- und Rechtsanwaltsgesellschaft mbH
Elisenhof
Elisenstraße 3
80335 München (DE)**

(56) References cited:
**CN-A- 101 640 541    CN-A- 101 895 297**

**CN-A- 101 908 889    US-A1- 2009 141 995**

• T. TONY CAI ET AL: "Orthogonal Matching Pursuit for Sparse Signal Recovery With Noise", IEEE TRANSACTIONS ON INFORMATION THEORY, vol. 57, no. 7, 1 July 2011 (2011-07-01), pages 4680-4688, XP055199446, ISSN: 0018-9448, DOI: 10.1109/TIT.2011.2146090
• GAO RUI ET AL: "Variable Step Size Adaptive Matching Pursuit Algorithm for Image Reconstruction Based on Compressive Sensing", GUANXUE XUEBAO - ACTA OPTICA SINICA, SHANGHAI KEXUE JISHU CHUBANSHE, SHANGHAI, CN, vol. 30, no. 6, 1 June 2010 (2010-06-01), pages 1639-1644, XP008176813, ISSN: 0253-2239
• GAO, RUI: 'Matching Pursuit Algorithm for Image Reconstruction Based on Compressive Sensing' CHINESE MASTER'S THESES FULL-TEXT DATABASE (INFORMATION SCIENCE AND TECHNOLOGY) 28 February 2010, pages 8 - 9, XP008174290
• TROPP, JOEL A. ET AL.: 'Signal Recovery From Random Measurements Via Orthogonal Matching Pursuit.' IEEE TRANSACTIONS ON INFORMATION THEORY. vol. 53, no. 12, December 2007, XP007909409
• LIU, BING ET AL.: 'Compressive Sensing Signal Detection Algorithm Based on Orthogonal Matching Pursuit' CHINESE JOURNAL OF SCIENTIFIC INSTRUMENT vol. 31, no. 9, 30 December 2010, pages 1959 - 1964, XP008174241

**Description**

**TECHNICAL FIELD**

The present invention relates to the communications field, and in particular, to a signal reconstruction method and apparatus.

**BACKGROUND**

A conventional signal processing process may include four parts, namely, sampling, compression, storage/transmission, and decompression. In the sampling process, data collection is first performed for an original signal according to the Nyquist (Nyquist) sampling theorem, and then the collected data is compressed. In the compression process, the collected data is transformed first, and then a few coefficients with large absolute values are compressed and encoded, and other coefficients equal or close to zero are discarded. In the compression process, a majority of data obtained through the sampling is discarded.

The article by T. TONY CAI ET AL: titled "Orthogonal Matching Pursuit for Sparse Signal Recovery with Noise", published in IEEE TRANSACTIONS ON INFORMATION THEORY, vol. 57, no. 7, 1 July 2011 (2011-07-01), pages 4680-4688 describes a system and method for orthogonal matching pursuit for sparse signal recovery with noise.

The article by GAO RUI ET AL: titled "Variable Step Size Adaptive Matching Pursuit Algorithm for Image Reconstruction Based on Compressive Sensing", published in GUANXUE XUEBAO - ACTA OPTICA SINICA, SHANGHAI KEXUE JISHU CHUBANSHE, SHANGHAI, CN, vol. 30, no. 6, 1 June 2010 (2010-06-01), pages 1639-1644 describes systems and methods for variable step size adaptive matching pursuit algorithm for image reconstruction based on compressive sensing.

In recent years, a new signal collection technology has been put forward, that is, a compressed sensing technology. The compressed sensing technology takes advantage of a feature that an original signal **S** is sparse. That is to say, the original signal has only K_sparse non-zero items with unknown positions after experiencing orthogonal transformation. The amount of data measured by using the compressed sensing technology is much smaller than the amount of data required in conventional sampling.

In the process of implementing compressed sensing, a measured value (non-adaptive linear projection) of the original signal **S** is obtained first, where the measured value is represented by equation (1.1):

$$\mathbf{y} = \mathbf{\Phi}\, \mathbf{s} \qquad\qquad (1.1)$$

In the above equation, **y** is the measured value, $\Phi$ is a measurement matrix, and **S** is the original signal. The original signal **S** is represented as a column vector with N items, and has a sparse expression. That is to say, $\Psi\mathbf{s} = \mathbf{x}$ obtained after orthogonal transformation $\Psi$ has only K_sparse (K_sparse << N) non-zero items with unknown positions. The measured value **y** is a column vector with M items (M << N & M > 2K_sparse), and the measurement matrix $\Phi$ has M rows and N columns.

After the measured value **y** of the original signal is obtained and then stored/transmitted, signal reconstruction may be performed. In the prior art, a signal reconstruction method is: First, under a constraint condition $\mathbf{y} = \mathbf{T}\mathbf{x}$, **X** is found; and then according to equation $\mathbf{s} = \Psi^H\mathbf{x}$, **S** is calculated, where a matrix $\mathbf{T} = \Phi\Psi^H$ is called a sensing matrix, $\Phi$ is a measurement matrix, and $\Psi$ is the orthogonal transformation. The sensing matrix **T** is also called a dictionary (dictionary), and each column in the dictionary is also referred to as an atom.

The signal can be reconstructed by using an orthogonal matching pursuit method, which is specifically implemented through the following steps:

Step 1: First, initialize variables for iteration, which is detailed as follows:

Step 1.1: Set an initial value $\tilde{\mathbf{y}}$ of a residual error to make $\tilde{\mathbf{y}} = \mathbf{y}$.
Step 1.2: Set an initial value of a base matrix B to be an empty matrix: $\mathbf{B}_0 = []$. The base matrix B selects column K that best matches a received signal y from a dictionary T to build a sparse approximation of y, and an index of a column already selected by the base matrix B is denoted as a column vector $\tau$, and its initial value $\tau_0$ is an empty vector.

Step 1.3: Before the $k^{th}$ iteration in an iteration process starts, denote a column that is not selected into the base matrix B in a sensing matrix as $T_{N+1-k} = T_{\mathbb{N}^-(k-1)}$, where $\mathbb{N}^-(k-1) = N - k + 1$,

$T_{N+1-k} = T_{\mathbb{N}^-(k-1)}$ has N+1-k columns, and an initial value is $\mathbf{T}_N = \mathbf{T}$.

An initial value of an estimated value of sparse expression x is set to $\hat{\mathbf{x}} = \mathbf{0}_N$, where $\mathbf{0}_N$ represents a zero column vector with N items, that is, a column vector with each item being zero.

The modulus of each column in the sensing matrix T is denoted as a column vector $\delta_{N-(0)} = [\|t_{(1)}\|_2 \ \|t_{(2)}\|_2 \cdots \|t_{(N)}\|_2]^T$, where $\mathbf{t}_{(i)}$(i= 1, 2, ..., N) represents the i$^{th}$ column of T, $\|t_{(i)}\|_2$ represents the modulus of a vector $\mathbf{t}_{(i)}$, and $[\cdot]^T$ represents transposition of the vector or a matrix $[\cdot]$.

A column vector $\pi_{N^-(0)} = \pi_N = [1 \ 2 \cdots N]^T$ records sequence numbers of atoms that are not selected into the base matrix B.

Step 2: The initial value of k is 1. Then the following iteration starts.

Step 2.1: Calculate, by using formula (1.2), a correlation between the k$^{th}$ residual error and each column in the sensing matrix from which k-1 columns are deleted:

$$\mathbf{q}_{\mathbb{N}^-(k-1)} = \mathbf{T}_{\mathbb{N}^-(k-1)}^{H} \tilde{\mathbf{y}}$$

$$(1.2)$$

In the above formula, $\mathbb{N}^-(k-1) = N - k + 1$, $T_{\mathbb{N}^-(k-1)}$ represents a matrix with M rows and $\mathbb{N}^-(k-1)$ columns, and when k = 1, the residual error $\tilde{\mathbf{y}} = \mathbf{y}$, that is, the residual error $\tilde{\mathbf{y}}$ is equal to a measured value vector; and when k = 1, $T_{\mathbb{N}^-(k-1)} = T_{\mathbb{N}^-(0)} = T_N = T_{\mathbb{N}^-(0)} = \mathbf{T}$, that is, $T_{\mathbb{N}^-(k-1)}$ is the sensing matrix $\mathbf{T}$; and $\mathbf{q}_{\square^-(k-1)}$ is a column vector with $\mathbb{N}^-(k-1)$ items, and its i$^{th}$ item represents the value of correlation between the i$^{th}$ column of $T_{\mathbb{N}^-(k-1)}$ and the residual error $\tilde{\mathbf{y}}$. It should be noted that, $T_{\mathbb{N}^-(k-1)}$ includes $\mathbb{N}^-(k-1)$ columns, which are $\mathbb{N}^-(k-1)$ columns to be selected in the sensing matrix $\mathbf{T}$, that is, $\mathbb{N}^-(k-1)$ atoms to be selected in the sensing matrix $\mathbf{T}$; and $T_{\mathbb{N}^-(k-1)}$ is obtained by deleting k-1 columns from the sensing matrix $\mathbf{T}$, where the k-1 columns have been selected and placed into the base matrix.

Step 2.2: Determine, by using formula (1.3), a sequence number of a column with the maximum correlation value:

$$\rho_k = \operatorname*{argmax}_{i=1}^{\mathbb{N}^-(k-1)} |q_i| / \delta_i$$

$$(1.3)$$

In the above formula, $q_i$ represents the i$^{th}$ item of $q_{N^-(k-1)}$, $\delta_i$ represents the i$^{th}$ item of $\delta_{N^-(k-1)}$, $\delta_{N^-(k-1)}$ is a modulus of each column of $T_{\mathbb{N}^-(k-1)}$, and $|\cdot|$ represents the absolute value of a scalar $\cdot$.

Step 2.3: Update the column $T_{\mathbb{N}^-(k-1)}$ to be selected by the selected base matrix B and the sensing matrix. A k$^{th}$ column is added to the base matrix B to make $\mathbf{B}_k = [\mathbf{B}_{k-1} \ \mathbf{t}_{(\rho k)}]$, where $\mathbf{t}_{(\rho k)}$ represents the $\rho_k{}^{th}$ column of $T_{\mathbb{N}^-(k-1)}$. Correspondingly, the $\rho_k{}^{th}$ column, $\mathbf{t}_{(\rho k)}$, is deleted from $T_{\mathbb{N}^-(k-1)}$ to obtain $T_{\mathbb{N}^-(k)}$ for subsequent iteration. The initial value $\mathbf{B}_{k-1} = \mathbf{B}_{I-1} = \mathbf{B}_0$ of the base matrix B is an empty matrix.

Step 2.4: According to $\tau_{k-1}$, obtain an index $\tau_k$ of each column of the base matrix $\mathbf{B}_k$; and according to an index $\pi_{\mathbb{N}^-(k-1)}$ of each column of $T_{\mathbb{N}^-(k-1)}$ and the modulus $\delta_{\mathbb{N}^-(k-1)}$ of each column, obtain an index $\pi_{\mathbb{N}^-(k)}$ of each column of $T_{\mathbb{N}^-(k)}$ and the modulus $\delta_{\mathbb{N}^-(k)}$ of each column.

$$\boldsymbol{\tau}_k = \begin{bmatrix} \boldsymbol{\tau}_{k-1}^T & \pi_{\rho_k} \end{bmatrix}^T$$ is obtained, where $\pi_{\rho_k}$ is the $\rho_k^{\text{th}}$ item in $\pi_{\square^-(k-1)}$; the $\rho_k^{\text{th}}$ item, $\pi_{\rho_k}$, is deleted from $\pi_{\mathbb{N}^-(k-1)}$ to obtain $\pi_{\mathbb{N}^-(k)}$ for subsequent iteration; and the $\rho_k^{\text{th}}$ item is deleted from $\delta_{\mathbb{N}^-(k-1)}$ to obtain $\delta_{\mathbb{N}^-(k)}$ for subsequent iteration.

Step 2.5: Update a weight coefficient of each column selected in the base matrix B and a corresponding residual error.

First, a column vector $\mathbf{z}_k$ composed of the weight coefficients of the columns selected in the base matrix B is calculated by using formula (1.4):

$$\mathbf{z}_k = \left( \mathbf{B}_k^H \mathbf{B}_k \right)^{-1} \mathbf{B}_k^H \mathbf{y}, \qquad (1.4)$$

In the above formula, $(\cdot)^{-1}$ represents an inverse matrix of the matrix $(\cdot)$. Then, the residual error $\tilde{\mathbf{y}}$ is obtained by using formula (1.5):

$$\tilde{\mathbf{y}} = \mathbf{y} - \mathbf{B}_k \mathbf{z}_k \qquad (1.5)$$

If k < K (generally, K is smaller than or equal to K_sparse), the value of k increases by 1, and the process goes back to step 1.

Step 3: Recover the signal.

The initial value of the estimated value of sparse expression x is $\hat{\mathbf{X}} = \mathbf{0}_N$. In $\hat{\mathbf{X}}$, let the $\tau_k^{\text{th}}$ item be $\hat{x}_{\tau_k} = z_k$ (k = 1,2,..,K), where $z_k$ is the $k^{\text{th}}$ item of $\mathbf{z}_K$, and $\tau_k$ is the $k^{\text{th}}$ item of the vector $\tau_k$. Then the original signal is calculated as $\hat{\mathbf{s}} = \Psi^H \hat{\mathbf{X}}$.

As can be seen from the above, when determining each column of the base matrix, it is necessary to determine the correlation between $T^H_{\mathbb{N}^-(k-1)}$ and each column of the residual error by using formula $q_{\mathbb{N}^-(k-1)} = T^H_{\mathbb{N}^-(k-1)} \tilde{y}$. $T^H_{\mathbb{N}^-(k-1)}$ is a vector with $\mathbb{N}^-(k-1)$ rows and N columns, where the value of N is very large; therefore, the complexity of calculating $T^H_{\mathbb{N}^-(k-1)} \tilde{y}$ is extremely high.

Therefore, an appropriate method is desired to ensure proper recovery of a signal and reduce the amount of calculation for reconstructing the signal.

## SUMMARY

Embodiments of the present invention provide a signal reconstruction method according to the independent claims.

## BRIEF DESCRIPTION OF DRAWINGS

To illustrate the technical solutions in the embodiments of the present invention more clearly, the following briefly introduces the accompanying drawings required for describing the embodiments or the prior art. Apparently, the accompanying drawings in the following description show merely some embodiments of the present invention, and a person of ordinary skill in the art may still derive other drawings from these accompanying drawings without creative efforts.

FIG. 1 is a schematic flowchart of a signal reconstruction method according to an embodiment of the present invention;
FIG. 2 is a schematic flowchart of a signal reconstruction method according to another embodiment of the present invention;
FIG. 3 is a schematic flowchart of a signal reconstruction method according to another embodiment of the present invention;
FIG. 4 is a schematic flowchart of a signal reconstruction method according to an embodiment of the present invention;

FIG. 5 is a schematic flowchart of a signal reconstruction method according to an embodiment of the present invention;

FIG. 6 is a diagram of comparison between simulation results of a signal reconstruction method in the prior art and a signal reconstruction method in an embodiment of the present invention;

FIG. 7 is a schematic block diagram of a signal reconstruction apparatus according to an embodiment of the present invention;

FIG. 8 is a schematic block diagram of a signal reconstruction apparatus according to another embodiment of the present invention; and

FIG. 9 is a schematic block diagram of a signal reconstruction apparatus according to another embodiment of the present invention.

## DESCRIPTION OF EMBODIMENTS

The following clearly and completely describes the technical solutions in the embodiments of the present invention with reference to the accompanying drawings in the embodiments of the present invention. Apparently, the described embodiments are merely a part rather than all of the embodiments of the present invention. All other embodiments obtained by a person of ordinary skill in the art based on the embodiments of the present invention without creative efforts shall fall within the protection scope of the present invention.

The technical solutions of the present invention are applicable to various communication systems, such as GSM, code division multiple access (CDMA, Code Division Multiple Access) system, wideband code division multiple access wireless (WCDMA, Wideband Code Division Multiple Access Wireless), general packet radio service (GPRS, General Packet Radio Service), long term evolution (LTE, Long Term Evolution), and the like.

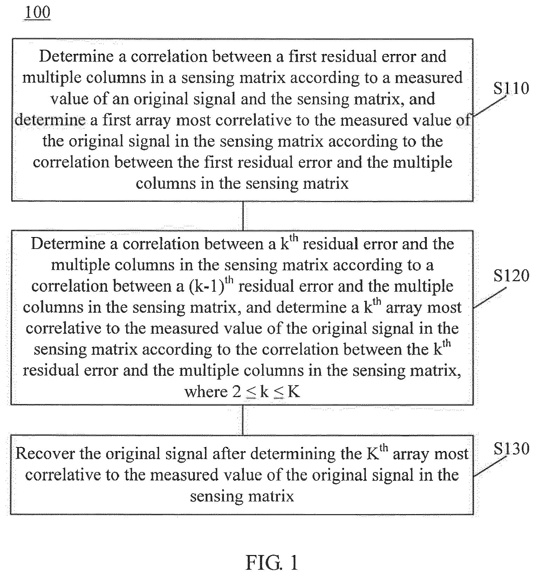

FIG. 1 is a schematic flowchart of a signal reconstruction method 100 according to an embodiment of the present invention. As shown in FIG. 1, the method 100 includes:

S110. Determine a correlation between a first residual error and multiple columns in a sensing matrix according to a measured value of an original signal and the sensing matrix, and determine a first array most correlative to the measured value of the original signal in the sensing matrix according to the correlation between the first residual error and the multiple columns in the sensing matrix.

S120. Determine a correlation between a $k^{th}$ residual error and the multiple columns in the sensing matrix according to a correlation between a $(k-1)^{th}$ residual error and the multiple columns in the sensing matrix, and determine a $k^{th}$ array most correlative to the measured value of the original signal in the sensing matrix according to the correlation between the $k^{th}$ residual error and the multiple columns in the sensing matrix, where $2 \leq k \leq K$.

S130. Recover the original signal after determining the $K^{th}$ array most correlative to the measured value of the original signal in the sensing matrix.

In the embodiment of the present invention, in S120, the determining a correlation between a $k^{th}$ residual error and the multiple columns in the sensing matrix according to a correlation between a $(k-1)^{th}$ residual error and the multiple columns in the sensing matrix includes:

from the correlation between the $(k-1)^{th}$ residual error and the multiple columns in the sensing matrix, subtracting a product of a $(k-1)^{th}$ base difference and a $(k-1)^{th}$ difference coefficient to obtain the correlation between the $k^{th}$ residual error and

the multiple columns in the sensing matrix, where the $k^{th}$ base difference is a vector or a vector set, and the $(k-1)^{th}$ difference coefficient is a scalar or a scalar set or a set of vectors composed of multiple scalars.

In the embodiment of the present invention, before the from the correlation between the $(k-1)^{th}$ residual error and the multiple columns in the sensing matrix, subtracting a product of a $(k-1)^{th}$ base difference and a $(k-1)^{th}$ difference coefficient to obtain the correlation between the $k^{th}$ residual error and the multiple columns in the sensing matrix, the determining a correlation between a $k^{th}$ residual error and the multiple columns in the sensing matrix in S120 further includes:

if $k = 2$, determining a first base difference;
if $k = 3$, determining the $(k-1)^{th}$ base difference according to a first base difference; or
if $k \geq 4$, determining the $(k-1)^{th}$ base difference according to first to $(k-2)^{th}$ base differences.

Therefore, in the embodiment of the present invention, the correlation between the $k^{th}$ residual error and the multiple columns in the sensing matrix is determined according to the correlation between the $(k-1)^{th}$ residual error and the multiple columns in the sensing matrix, and a column most correlative to the measured value of the original signal in the sensing matrix is further determined for recovering the signal. In this way, under the premise of ensuring proper recovery of the signal, the amount of calculation for reconstructing the signal can be reduced.

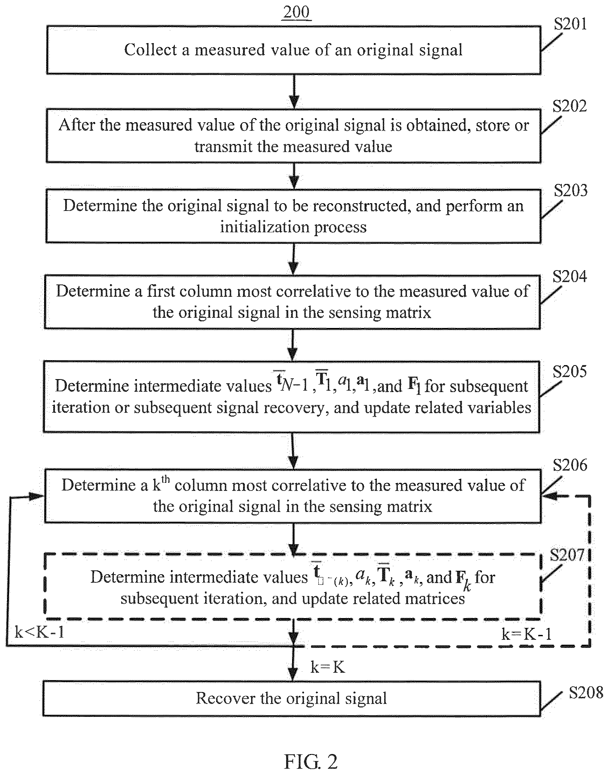

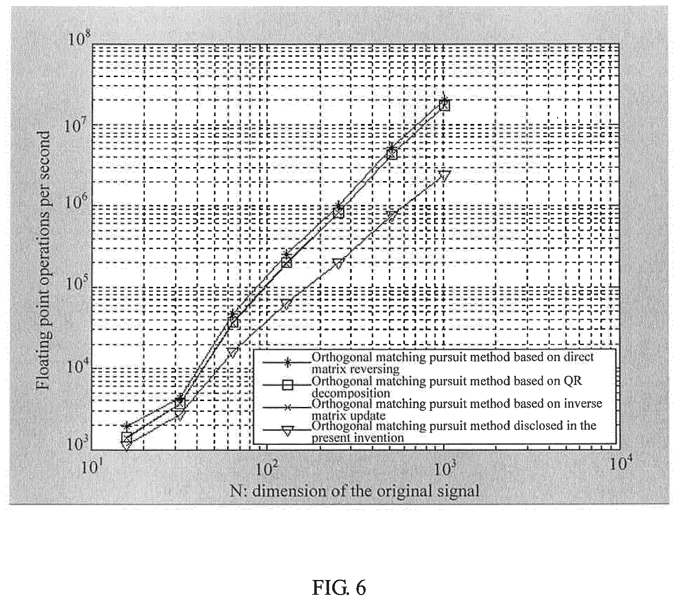

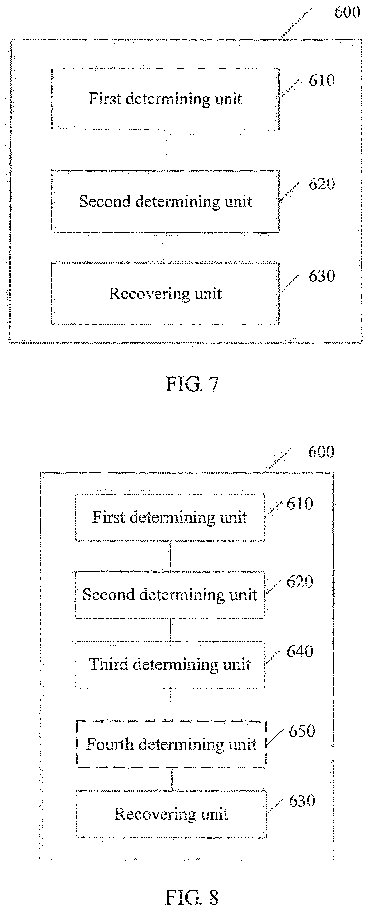

To enable clearer understanding of the present invention, the following describes in detail the signal reconstruction method in the embodiments of the present invention with reference to FIG. 2 to FIG. 7.

FIG. 2 is a schematic flowchart of a signal reconstruction method 200 according to an embodiment of the present invention. As shown in FIG. 2, the method 200 includes:

S201. Collect a measured value (non-adaptive linear projection) of an original signal, where the measured value may be represented by equation (2.1):

$$\mathbf{y} = \mathbf{\Phi}\,\mathbf{s} \qquad (2.1)$$

In the above equation, $\mathbf{y}$ is a measured value vector, $\Phi$ is a measurement matrix, and $\mathbf{S}$ is the original signal.

S202. After the measured value of the original signal is obtained, store or transmit the measured value.

S203. Determine the original signal to be reconstructed. First, perform an initialization process, where the initialization process may include the following steps:

(1) Set an initial value $\tilde{\mathbf{y}} = \mathbf{y}$ of a residual error, that is, set the initial value of the residual error to be a measured value vector.

(2) Set an initial value of an estimated value of sparse expression x to $\hat{\mathbf{x}}=\mathbf{0}_N$.

(3) Set a sensing matrix $\mathbf{T} = \Phi\Psi^H$, where the sensing matrix is an N×N matrix; and denote the modulus of columns in the sensing matrix $\mathbf{T}$ as $\delta_{\square^-(0)} = [\|\mathbf{t}_{(1)}\|_2\ \|\mathbf{t}(2)\|_2 \cdots \|\mathbf{t}_{(N)}\|_2]$, where $\mathbf{t}_{(i)}$(i = 1, 2, ..., N) represents the $i^{th}$ column of T, and $\|\mathbf{t}_{(i)}\|_2$ represents the modulus of the vector $\mathbf{t}_{(i)}$. $\pi_{\square^-(0)}$ is set, where $\pi_{\square^-(0)} = [1\ 2 \cdots N]^T$ records a sequence number of each column of the sensing matrix, and is an initial value of an atom sequence number set to be selected. In subsequent $k^{th}$ (k = 1, 2, ..., N) iteration, after an atom is selected into a base matrix, a sequence number of the atom is deleted from a vector $\pi_{\square^-(k-1)}$ correspondingly. An index of a selected column of the base matrix B is denoted as a column vector $\tau$, and its initial value $\tau_0$ is an empty vector.

(4) Calculate and store a correlation matrix $\Theta = \mathbf{T}^H\mathbf{T}$ of the sensing matrix, or calculate and store off-diagonal items (that is, items that are not on the diagonal) of a correlation matrix $\Theta = \mathbf{T}^H\mathbf{T}$ of the sensing matrix. It should be noted that, because the sensing matrix $\mathbf{T}$ is generally constant, or at least constant in a long time, it is not necessary to calculate the correlation matrix $\Theta = \mathbf{T}^H\mathbf{T}$ of the sensing matrix on every occasion of reconstructing the original signal. After the correlation matrix $\Theta = \mathbf{T}^H\mathbf{T}$ of the sensing matrix is calculated and stored, the stored correlation matrix $\Theta = \mathbf{T}^H\mathbf{T}$ is reusable in subsequent reconstruction of the original signal and the correlation matrix does not need to be calculated again.

S204. Determine a first column most correlative to the measured value of the original signal in the sensing matrix, which may include the following steps:

(1) Calculate a correlation between a first residual error and each column in the sensing matrix by using formula (2.2):

$$\mathbf{q}_N = \mathbf{T}_N^{H}\tilde{\mathbf{y}} = \mathbf{T}_N^{H}\mathbf{y} \qquad (2.2)$$

The first residual error is the initial value of the residual error, and is equal to the measured value vector. Meanwhile, the correlation between the first residual error and each column in the sensing matrix $\mathbf{T}_N$ is recorded by using $\tilde{\mathbf{q}}_N = \mathbf{q}_N$.

(2) Find a sequence number $\rho_1$ of a column with the maximum correlation value by using formula (2.3):

$$\rho_1 = \operatorname*{argmax}_{i=1}^{\square^-(k-1)} q_i\,/\,\delta_i \qquad (2.3)$$

Therefore, it can be determined that the $\rho_1{}^{th}$ column in the sensing matrix is the first column most correlative to the measured value of the original signal in the sensing matrix.

S205. Determine intermediate values $\bar{t}_{N-1}$, $\overline{T}_1$, $a_1$, $\mathbf{a}_1$, and $\mathbf{F}_1$ for subsequent iteration or subsequent signal recovery, and update related variables.

First, an intermediate parameter $\lambda_1$ is calculated by using formula (2.4):

$$\lambda_1 = \sqrt{1 / \theta_{\rho_1,\rho_1}} \qquad (2.4),$$

where, $\theta_{\rho_1,\rho_1}$ is an item in a $\rho_1{}^{th}$ row and a $\rho_1{}^{th}$ column of

$$\Theta_{\bar{\square}^-(0)}.$$

Then, intermediate parameters $\bar{t}_{N-1}$ (that is, a first base difference) and $a_1$ (that is, a first difference coefficient) are calculated respectively for subsequent iteration by using formulas (2.5) and (2.6):

$$\bar{t}_{N-1} = \lambda_1 \cdot \Theta_{(\rho_1)} \qquad (2.5)$$

$$a_1 = \lambda_1 \tilde{q}_{\rho_1} \qquad (2.6)$$

In the above formulas,

$$\Theta_{(\rho_1)}$$

is obtained by deleting the $\rho_1{}^{th}$ item $\theta_{\rho_1,\rho_1}$ in the $\rho_1{}^{th}$ column $\theta_{(\rho_1)}$ of

$$\Theta_{\bar{\square}^-(0)},$$

and $\tilde{q}_{\rho_1}$, is the $\rho_1{}^{th}$ item of $\tilde{\mathbf{q}}_N$.

(3) Calculate parameters $\overline{T}_1$ and $\mathbf{a}_1$ for subsequent iteration by using the following formulas (2.7) and (2.8):

$$\overline{T}_1 = \left[ \bar{t}_{N-1} \right] \qquad (2.7)$$

$$\mathbf{a}_1 = \left[ a_1 \right] \qquad (2.8)$$

(4) Calculate a parameter $\mathbf{F}_1$ for subsequent iteration by using the following formula (2.9):

$$\mathbf{F}_1 = \left[ \lambda_1 \right] \qquad (2.9)$$

(5) According to $\tau_{k-1}$, obtain an index $\tau_k$ of each column of the base matrix $\mathbf{B}_k$; and according to an index $\pi_{\square^-(k-1)}$ of each column of $\mathbf{T}_{\square^-(k-1)}$ and the modulus $\delta_{\square^-(k-1)}$ of each column, obtain an index $\pi_{\square^-(k)}$ of each column of $\mathbf{T}_{\square^-(k)}$ and the modulus $\delta_{\square^-(k)}$ of each column respectively: $\tau_k = \left[ \tau_{k-1}^T \quad \pi_{\rho_k} \right]^T$ is obtained, where $\pi_{\rho_k}$ is the $\rho_k{}^{th}$ item in $\pi_{\square^-(k-1)}$; the $\rho_k{}^{th}$ item $\pi_{\rho_k}$ is deleted from $\pi_{\square^-(k-1)}$ to obtain $\pi_{\square^-(k)}$ for subsequent iteration; and the $\rho_k{}^{th}$ item is deleted from $\delta_{\square^-(k-1)}$ to obtain $\delta_{\square^-(k)}$ for subsequent iteration. It should be noted that, the current k is equal to 1.

(6) Update $\tilde{\mathbf{q}}_{\square^-(0)}$, $\mathbf{q}_{\square^-(0)}$, and $\Theta_{\square^-(0)}$ to $\tilde{\mathbf{q}}_{\square^-(1)}$, $\mathbf{q}_{\square^-(0)}$, and $\Theta_{\square^-(1)}$ respectively, that is,

delete the $\rho_1{}^{th}$ item $\tilde{q}_{\rho_1}$ from $\tilde{\mathbf{q}}_{\square^-(0)}$ to obtain $\tilde{\mathbf{q}}_{\square^-(1)}$ ;

delete the $\rho_1{}^{th}$ item from $\mathbf{q}_{\square^-(0)}$ to obtain $\mathbf{q}_{\square^-(1)}$ ; and

delete the $\rho_1{}^{th}$ row and the $\rho_1{}^{th}$ column from $\Theta_{\square^-(0)}$ to obtain $\Theta_{\square^-(1)}$.

S206. Determine a $k^{th}$ column most correlative to the measured value of the original signal in the sensing matrix, where an initial value of k is 2, which may specifically include the following steps:

(1) Calculate, by using formula (2.10), a correlation $\mathbf{q}_{\square^-(k-1)}$ between a $k^{th}$ residual error and each column in $\mathbf{T}_{\square^-(k-1)}$ (that is, $\square^-$(k-1) columns to be selected in the sensing matrix $\mathbf{T}$), that is:

$$\mathbf{q}_{\square^-(k-1)} = \mathbf{q}_{\square^-(k-2)} - \overline{\mathbf{t}}_{\square^-(k-1)} a_{k-1} \qquad (2.10)$$

In the above formula, the vector $\overline{\mathbf{t}}_{\square^-(k-1)}$ is a $(k-1)^{th}$ base difference, and the scalar $a_{k-1}$ is a $(k-1)^{th}$ difference coefficient, which have been obtained in preceding steps. (2) Determine a sequence number $\rho_k$ of a column with the maximum correlation value by using formula (2.11):

$$\rho_k = \underset{i=1}{\overset{\square^-(k-1)}{\arg\max}} q_i / \delta_i \qquad (2.11)$$

In the above formula, $q_i$ is an $i^{th}$ item of $\mathbf{q}_{\square^-(k-1)}$, and $\delta_i$ is an $i^{th}$ item of $\delta_{\square^-(k-1)}$.

Therefore, it can be determined that, among columns of $\mathbf{T}_{\square^-(k-1)}$ (that is, the $\square^-$(k-1) column to be selected in the sensing matrix, and in other words, the sensing matrix cleared of k-1 columns selected into the base matrix), the $\rho_k{}^{th}$ column is a column most correlative to the measured value of the original signal in $\mathbf{T}_{\square^-(k-1)}$.

S207. Determine intermediate values $\overline{\mathbf{t}}_{\square^-}(k)$, $\alpha_k$, $\overline{T}_k$, $a_k$, and $\mathbf{F}_k$ for subsequent iteration or subsequent signal recovery, and update related variables.

(1) From the previously calculated $\overline{\mathbf{T}}_{k-1}$, obtain the $\rho_k{}^{th}$ row $\overline{\mathbf{t}}_{(\rho_k,:)}^H$ to make $\tilde{\mathbf{u}}_{k-1} = \left( \overline{\mathbf{t}}_{(\rho_k,:)}^H \right)^H$ ; and then, from $\Theta_{\square^-(k-1)}$, obtain an item $\theta_{\rho_k,\rho_k}$ in the $\rho_k{}^{th}$ row and the $\rho_k{}^{th}$ column, so as to determine $\lambda_k$ by using the following formula (2.12):

$$\lambda_k = 1 / \sqrt{\theta_{\rho_k,\rho_k} - \tilde{\mathbf{u}}_{k-1}^H \tilde{\mathbf{u}}_{k-1}} \qquad (2.12)$$

(2) Calculate intermediate values $\overline{\mathbf{t}}_{\square^-(k)}$ (that is, a $k^{th}$ base difference) and $a_k$ (that is, a $k^{th}$ difference coefficient) for subsequent iteration by using the following formulas (2.13) and (2.14):

$$\overline{\mathbf{t}}_{\square^-(k)} = -\lambda_k \overline{\overline{\mathbf{T}}}_{k-1} \tilde{\mathbf{u}}_{k-1} + \lambda_k \theta_{(\rho_k)} \qquad (2.13)$$

$$a_k = \lambda_k (\tilde{q}_{\rho_k} - \tilde{\mathbf{u}}_{k-1}^H \mathbf{a}_{k-1}) \qquad (2.14)$$

In the above formulas, $\overline{\overline{\mathbf{T}}}_{k-1}$ is obtained by deleting the $\rho_k{}^{th}$ row $\overline{\mathbf{t}}_{(\rho_k,:)}^H$ from $\overline{\mathbf{T}}_{k-1}$, $\theta_{(\rho_k)}$ is obtained by deleting

the $\rho_k$<sup>th</sup> item $\theta_{\rho k,\rho k}$ from the $\rho_k$<sup>th</sup> column $\theta_{(\rho k)}$ of $\Theta_{\Box^-(k-1)}$, and $\tilde{q}_{\rho k}$ is the $\rho_k$<sup>th</sup> item of $\tilde{\mathbf{q}}_{\Box^-(k-1)}$. In addition, $a_k$ may be calculated by using $a_k = \lambda_k q_{\rho_k}^{\Box^-(k-1)}$, where $q_{\rho_k}^{\Box^-(k-1)}$ is the $\rho_k$<sup>th</sup> item of $\mathbf{q}_{\Box^-(k-1)}$.

(3) Obtain intermediate parameters $\overline{\mathbf{T}}_k$ and $\mathbf{a}_k$ for subsequent iteration by using the following formulas (2.15) and (2.16):

$$\overline{\mathbf{T}}_k = \begin{bmatrix} \overline{\overline{\mathbf{T}}}_{k-1} & \overline{\mathbf{t}}_{\Box^-(k)} \end{bmatrix} \tag{2.15}$$

$$\mathbf{a}_k = \begin{bmatrix} \mathbf{a}_{k-1}^T & a_k \end{bmatrix}^T \tag{2.16}$$

(4) First, calculate $\mathbf{u}_{k-1}$ by using formula $\mathbf{u}_{k-1} = -\lambda_k \mathbf{F}_{k-1}\tilde{\mathbf{u}}_{k-1}$, and then calculate a parameter $\mathbf{F}_k$ for subsequent iteration by using the following formula (2.17):

$$\mathbf{F}_k = \begin{bmatrix} \mathbf{F}_{k-1} & \mathbf{u}_{k-1} \\ \mathbf{0}_{k-1}^T & \lambda_k \end{bmatrix} \tag{2.17}$$

It can be easily seen that, $\mathbf{u}_{k-1}$ and $\mathbf{F}_k$ are not used in iterations until in recovering the original signal (that is, in S208). Therefore, it is not necessary to calculate $\mathbf{u}_{k-1}$ and $\mathbf{F}_k$ in every iteration, thereby reducing the amount of calculation in each iteration and improving the speed of each iteration. $\mathbf{F}_k$ may also be calculated by other methods.

(5) According to $\tau_{k-1}$, obtain an index $\tau_k$ of each column of the base matrix $\mathbf{B}_k$; and according to an index $\pi_{\Box^-(k-1)}$ of each column of $\mathbf{T}_{\Box^-(k-1)}$ and the modulus $\delta_{\Box^-(k-1)}$ of each column, obtain an index $\pi_{\Box^-(k)}$ of each column of $\mathbf{T}_{\Box^-(k)}$ and the modulus $\delta_{\Box^-(k)}$ of each column respectively. $\tau_k = \begin{bmatrix} \tau_{k-1}^T & \pi_{\rho_k} \end{bmatrix}^T$ is obtained, where $\pi_{\rho k}$ is the $\rho_k$<sup>th</sup> item in $\pi_{\Box^-(k-1)}$; the $\rho_k$<sup>th</sup> item $\pi_{\rho k}$ is deleted from $\pi_{\Box^-(k-1)}$ to obtain $\pi_{\Box^-(k)}$ for subsequent iteration; and the $\rho_k$<sup>th</sup> item is deleted from $\delta_{\Box^-(k-1)}$ to obtain $\delta_{\Box^-(k)}$ for subsequent iteration.

(6) Update $\tilde{\mathbf{q}}_{\Box^-(k-1)}$, $\mathbf{q}_{\Box^-(k-1)}$, and $\Theta_{\Box^-(k-1)}$ to $\tilde{\mathbf{q}}_{\Box^-(k)}$, $\mathbf{q}_{\Box^-(k-1)}$ and $\Theta_{\Box^-(k)}$ respectively, that is,

delete the $\rho_k$<sup>th</sup> item $\tilde{q}_{\rho k}$ from $\tilde{\mathbf{q}}_{\Box-(k-1)}$ to obtain $\tilde{\mathbf{q}}_{\Box^-(k)}$ for subsequent iteration;
delete the $\rho_k$<sup>th</sup> item from $\mathbf{q}_{\Box^-(k-1)}$ to obtain $\mathbf{q}_{\Box^-(k-1)}$ for subsequent iteration; and
delete the $\rho_k$<sup>th</sup> row and the $\rho_k$<sup>th</sup> column from $\Theta_{\Box^-(k-1)}$ to obtain $\Theta_{\Box-(k)}$ for subsequent iteration.

(7) If $k < K - 1$, the process goes back to S206 and S207 after the value of k increases by 1; if $k = K - 1$, the process goes back to S206 and S207 after the value of k increases by 1, and subsequently S208 is performed. When S207 is performed, it is necessary only to calculate $a_K$, $\mathbf{a}_K$, and $\mathbf{F}_K$ for subsequent signal recovery.

S208. Recover the original signal, mainly including the following steps:

(1) Calculate, by using the following formula (2.18), a column vector $\mathbf{z}_K$ composed of weight coefficients of K columns selected in the base matrix B:

$$\mathbf{z}_K = \mathbf{F}_K \mathbf{a}_K \tag{2.18}$$

(2) The initial value of the estimated value of x is $\hat{\mathbf{x}} = \mathbf{0}_N$. In $\hat{\mathbf{x}}$, let the $\tau_k$<sup>th</sup> item be $\hat{x}_{\tau-k} = z_k$ (k = 1,2,..,K), where $z_k$ is the k<sup>th</sup> item of $\mathbf{z}_K$, and $\tau_k$ is the k<sup>th</sup> item of the vector $\tau_K$.

(3) Determine the original signal by using the following formula (2.19):

$$\hat{\mathbf{s}} = \mathbf{\Psi}^H \hat{\mathbf{x}} \tag{2.19}$$

The original signal $\hat{\mathbf{s}}$ is therefore obtained.

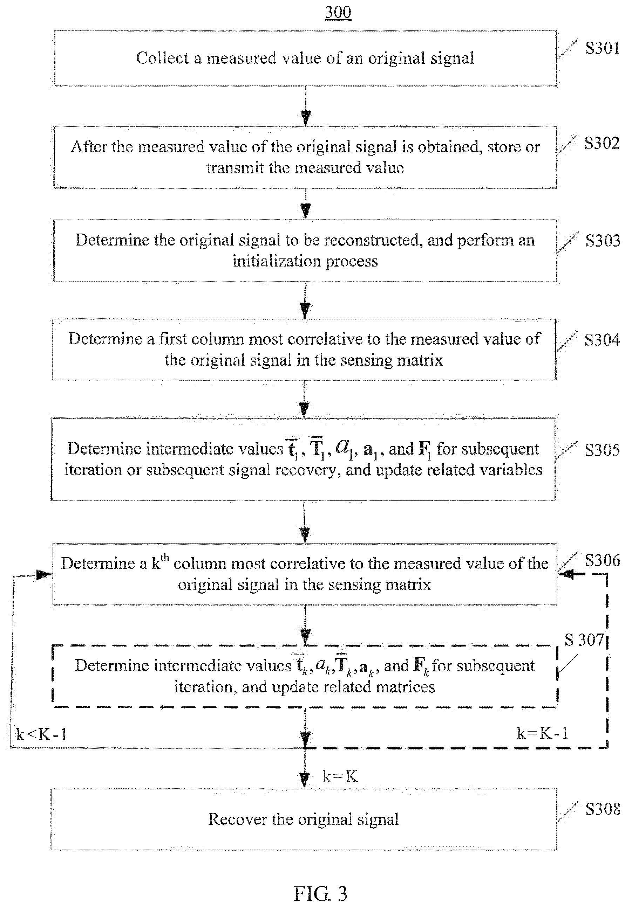

FIG. 3 is a schematic flowchart of a signal reconstruction method 300 according to an embodiment of the present invention. As shown in FIG. 3, the method 300 includes:

S301. Collect a measured value (non-adaptive linear projection) of an original signal, where the measured value may be represented by equation (3.1):

$$\mathbf{y} = \mathbf{\Phi}\,\mathbf{s} \tag{3.1}$$

In the above equation, $\mathbf{y}$ is a measured value vector, $\mathbf{\Phi}$ is a measurement matrix, and $\mathbf{s}$ is the original signal.

S302. After the measured value of the original signal is obtained, store or transmit the measured value.

S303. Determine the original signal to be reconstructed. First, perform an initialization process, where the initialization process may include the following steps:

(1) Set an initial value $\tilde{\mathbf{y}} = \mathbf{y}$ of a residual error, that is, set the initial value of the residual error to be a measured value vector.

(2) Set an initial value of an estimated value of sparse expression x to $\hat{\mathbf{x}} = \mathbf{0}_N$.

(3) Set a sensing matrix $\mathbf{T} = \mathbf{\Phi}\mathbf{\Psi}^H$, where the sensing matrix is an N×N matrix; and denote the modulus of columns in the sensing matrix $\mathbf{T}$ as $\delta = [\|\mathbf{t}_{(1)}\|_2\ \|\mathbf{t}_{(2)}\|_2 \cdots \|\mathbf{t}_{(N)}\|_2]$, where $\mathbf{t}_{(i)}(i = 1, 2, ..., N)$ represents the $i^{th}$ column of T, and $\|\mathbf{t}_{(i)}\|_2$ represents the modulus of the vector $\mathbf{t}_{(i)}$.

An index of a selected column of the base matrix B is denoted as a column vector $\tau$, and its initial value $\tau_0$ is an empty vector.

(4) Calculate and store a correlation matrix $\Theta = \mathbf{T}^H\mathbf{T}$ of the sensing matrix, or calculate and store off-diagonal items (that is, items that are not on the diagonal) of a correlation matrix $\Theta = \mathbf{T}^H\mathbf{T}$ of the sensing matrix. It should be noted that, because the sensing matrix $\mathbf{T}$ is generally constant, or at least constant in a long time, it is not necessary to calculate the correlation matrix $\Theta = \mathbf{T}^H\mathbf{T}$ of the sensing matrix on every occasion of reconstructing the original signal. After the correlation matrix $\Theta = \mathbf{T}^H\mathbf{T}$ of the sensing matrix is calculated and stored, the stored correlation matrix $\Theta = \mathbf{T}^H\mathbf{T}$ is reusable in subsequent reconstruction of the original signal and the correlation matrix does not need to be calculated again.

S304. Determine a first column most correlative to the measured value of the original signal in the sensing matrix, which may include the following steps:

(1) Calculate a correlation between a first residual error and each column in the sensing matrix by using formula (3.2):

$$\mathbf{q}^0 = \mathbf{T}_N^H \tilde{\mathbf{y}} = \mathbf{T}_N^H \mathbf{y} \tag{3.2}$$

The first residual error is the initial value of the residual error, and is equal to the measured value vector.

(2) Find a sequence number $\rho_1$ of a column with the maximum correlation value by using formula (3.3):

$$\rho_1 = \operatorname*{argmax}_{i=1}^{N} q_i^0 / \delta_i \tag{3.3},$$

where, $q_i^0$ is an $i^{th}$ item of $\mathbf{q}^0$. Therefore, it can be determined that the $\rho_1^{th}$ column in the sensing matrix is the first column most correlative to the measured value of the original signal in the sensing matrix.

S305. Determine intermediate values $\bar{\mathbf{t}}_1$, $\overline{\mathbf{T}}_1$, $a_1$, $\mathbf{a}_1$, and $\mathbf{F}_1$ for subsequent iteration or subsequent signal recovery, and update related variables, specifically including the following steps:

(1) Calculate an intermediate parameter $\lambda_1$ by using formula (3.4):

$$\lambda_1 = \sqrt{1 / \theta_{\rho_1,\rho_1}} \qquad (3.4),$$

where, $\theta_{\rho_1,\rho_1}$ is an item in a $\rho_1^{th}$ row and a $\rho_1^{th}$ column of $\Theta$.

(2) Calculate intermediate parameters $\bar{t}_1$; (that is, a first base difference) and $a_1$ (that is, a first difference coefficient) respectively for subsequent iteration by using formulas (3.5) and (3.6):

$$\bar{t}_1 = \lambda_1 \cdot \theta_{(\rho_1)} \qquad (3.5),$$

$$a_1 = \lambda_1 \tilde{q}_{\rho_1} \qquad (3.6),$$

where, $\theta_{(\rho_1)}$. is the $\rho_1^{th}$ column of $\Theta$, and $\tilde{q}_{\rho_1}$ is a $\rho_1^{th}$ item of $\tilde{\mathbf{q}}_N$.

(3) Calculate parameters $\bar{\mathbf{T}}_1$ and $\mathbf{a}_1$ for subsequent iteration by using the following formulas (3.7) and (3.8):

$$\bar{\mathbf{T}}_1 = \left[\, \bar{t}_1 \,\right] \qquad (3.7)$$

$$\mathbf{a}_1 = \left[\, a_1 \,\right] \qquad (3.8)$$

(4) Calculate a parameter $\mathbf{F}_1$ for subsequent iteration by using the following formula (3.9):

$$\mathbf{F}_1 = \left[\, \lambda_1 \,\right] \qquad (3.9)$$

(5) According to $\tau_{k-1}$, obtain an index $\tau_k$ of each column of the base matrix $\mathbf{B}_k$. $\tau_k = \left[\, \tau_{k-1}^T \quad \rho_k \,\right]^T$ is therefore obtained. It should be noted that, the current k is equal to 1.

S306. Determine a $k^{th}$ column most correlative to the measured value of the original signal in the sensing matrix, where an initial value of k is 2, which may specifically include the following steps:

(1) Calculate a correlation $\mathbf{q}^{k-1}$ between a $k^{th}$ residual error and each column in the sensing matrix $\mathbf{T}$ by using formula (3.10):

$$\mathbf{q}^{k-1} = \mathbf{q}^{k-2} - \bar{t}_{k-1} a_{k-1} \qquad (3.10)$$

In the above formula, the vector $\bar{t}_{k-1}$ is a $(k-1)^{th}$ base difference, and the scalar $a_{k-1}$ is a $(k-1)^{th}$ difference coefficient, which have been obtained in preceding steps. (2) Determine a sequence number $\rho_k$ of a column with the maximum correlation value by using formula (3.11):

$$\rho_k = \underset{i=1}{\overset{N}{\arg\max}} \left| q_i^{k-1} \right| / \delta_i \qquad (3.11),$$

where, $q_i^{k-1}$ is an $i^{th}$ item of $\mathbf{q}^{k-1}$, and $\delta_i$ is an $i^{th}$ item of $\delta$.

Therefore, it can be determined that, among columns of $\mathbf{T}$, the $\rho_k^{th}$ column is a column most correlative to the measured value vector of the original signal in $\mathbf{T}$.

S307. Determine intermediate values $\bar{t}_k$, $a_k$, $\bar{\mathbf{T}}_k$, $\mathbf{a}_k$, and $\mathbf{F}_k$ for subsequent iteration or subsequent signal recovery, and update related variables.

(1) From the previously calculated $\overline{\mathbf{T}}_{k-1}$, obtain the $\rho_k{}^{\text{th}}$ row $\overline{\mathbf{t}}_{(\rho_k,:)}^H$ to make $\tilde{\mathbf{u}}_{k-1} = \left( \overline{\mathbf{t}}_{(\rho_k,:)}^H \right)^H$ ; and then, from $\Theta$, obtain an item $\theta_{\rho_k,\rho_k}$ in the $\rho_k{}^{\text{th}}$ row and the $\rho_k{}^{\text{th}}$ column, so as to determine $\lambda_k$ by using the following formula (3.12):

$$\lambda_k = 1 \, / \, \sqrt{\theta_{\rho_k,\rho_k} - \tilde{\mathbf{u}}_{k-1}^H \tilde{\mathbf{u}}_{k-1}} \qquad (3.12)$$

(2) Calculate intermediate values $\overline{\mathbf{t}}_k$ (that is, a $k^{\text{th}}$ base difference) and $a_k$ (that is, a $k^{\text{th}}$ difference coefficient) for subsequent iteration by using the following formulas (2.13b) and (2.14b):

$$\overline{\mathbf{t}}_k = -\lambda_k \overline{\mathbf{T}}_{k-1} \tilde{\mathbf{u}}_{k-1} + \lambda_k \theta_{(\rho_k)} \qquad (3.13),$$

$$a_k = \lambda_k q_{\rho_k}^{k-1} \qquad (3.14),$$

where, $\overline{\mathbf{T}}_{k-1}$ is obtained in the previous iteration, $\theta_{(\rho_k)}$ is the $\rho_k{}^{\text{th}}$ column of $\Theta$, and $q_{\rho_k}^{k-1}$ is the $\rho_k{}^{\text{th}}$ item of $\mathbf{q}^{k-1}$.

(3) Obtain intermediate parameters $\overline{\mathbf{T}}_k$ and $\mathbf{a}_k$ for subsequent iteration by using the following formulas (3.15) and (3.16):

$$\overline{\mathbf{T}}_k = \begin{bmatrix} \overline{\mathbf{T}}_{k-1} & \overline{\mathbf{t}}_k \end{bmatrix} \qquad (3.15)$$

$$\mathbf{a}_k = \begin{bmatrix} \mathbf{a}_{k-1}^T & a_k \end{bmatrix}^T \qquad (3.16)$$

(4) According to $\tau_{k-1}$, obtain an index $\tau_k = \begin{bmatrix} \tau_{k-1}^T & \rho_k \end{bmatrix}^T$ of each column of the base matrix $\mathbf{B}_k$.

(5) First, calculate $\mathbf{u}_{k-1}$ by using formula $\mathbf{u}_{k-1} = -\lambda_k \mathbf{F}_{k-1} \tilde{\mathbf{u}}_{k-1}$ and then calculate a parameter $\mathbf{F}_k$ for subsequent iteration by using the following formula (3.17):

$$\mathbf{F}_k = \begin{bmatrix} \mathbf{F}_{k-1} & \mathbf{u}_{k-1} \\ \mathbf{0}_{k-1}^T & \lambda_k \end{bmatrix} \qquad (3.17)$$

It can be easily seen that, $\mathbf{u}_{k-1}$ and $\mathbf{F}_k$ are not used in iterations until in recovering the original signal (that is, in S208). Therefore, it is not necessary to calculate $\mathbf{u}_{k-1}$ and $\mathbf{F}_k$ in every iteration, thereby reducing the amount of calculation in each iteration and improving the speed of each iteration. $\mathbf{F}_k$ may also be calculated by other methods than the method disclosed in the present invention.

It should be understood that, if k < K - 1 (generally, K is smaller than or equal to K_sparse), the process goes back to S306 and S307 after the value of k increases by 1; if k = K - 1, the process goes back to S306 and S307 after the value of k increases by 1, and subsequently S308 is performed. When S307 is performed, it is necessary only to calculate $a_K$, $\mathbf{a}_K$, and $\mathbf{F}_K$ for subsequent signal recovery.

S308. Recover the original signal, mainly including the following steps:

(1) Calculating, by using the following formula (3.18) a column vector $\mathbf{z}_K$ composed of weight coefficients of K columns selected in the base matrix B:

$$\mathbf{z}_K = \mathbf{F}_K \mathbf{a}_K \qquad\qquad (3.18)$$

(2) The initial value of the estimated value of x is $\hat{\mathbf{x}} = \mathbf{0}_N$. In $\hat{\mathbf{x}}$, let the $\tau_k{}^{th}$ item be $\hat{x}_{\tau_k} = z_k$ (k = 1,2,..,K), where $z_k$ is the k$^{th}$ item of $\mathbf{z}_K$, and $\tau_k$ is the k$^{th}$ item of the vector $\tau_K$.

(3) Determine the original signal by using the following formula (3.19):

$$\hat{\mathbf{s}} = \mathbf{\Psi}^H \hat{\mathbf{x}} \qquad\qquad (3.19)$$

The original signal $\hat{\mathbf{s}}$ is therefore obtained.

The method according to the present invention is applied to many communication systems or signal processing systems. For example, the technical solutions of the present invention are applicable to a system described in the document [1] ("From Theory to Practice: Sub-Nyquist Sampling of Sparse Wideband Analog Signals," IEEE JOURNAL OF SELECTED TOPICS IN SIGNAL PROCESSING, VOL. 4, NO. 2, APRIL 2010). For ease of understanding, the system is described in detail as follows with reference to FIG. 3.

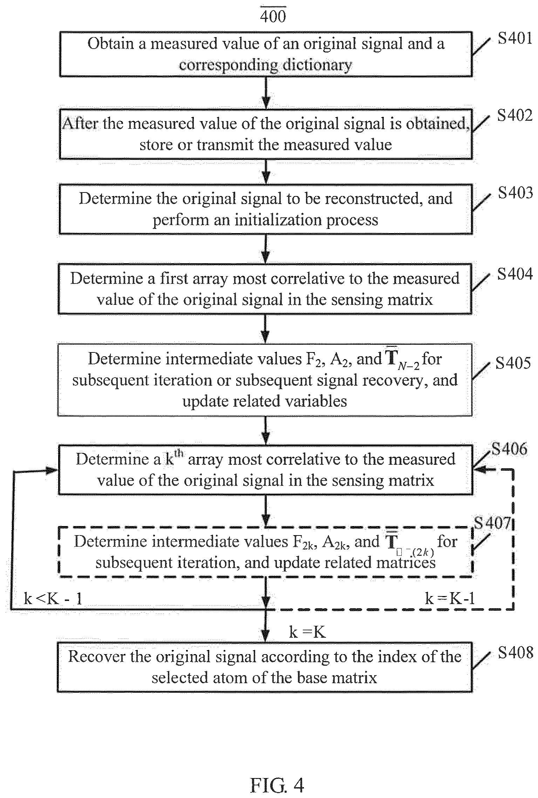

As shown in FIG. 4, an original signal x(t) includes Num_band narrowband signals (a positive frequency counts as a narrow-band signal, and a negative frequency counts as a narrow-band signal); and there are m channels in total, and each channel processes and collects samples of analog signals x(t) respectively. In each channel, a pseudo-random sequence is multiplied by the analog signal x(t) first, a result of the multiplication passes through a low-pass filter h(t), and then a low-rate analog-to-digital converter (Analog-to-Digital Converter, abbreviated as "ADC") collects samples of the signals. Subsequently, according to sample sequences y1[n], y2[n], ..., ym[n], (n = 1, 2, ..., Num_sample) obtained by the channels, an original signal x is recovered through a signal reconstruction method. A sample sequence of the i$^{th}$ channel is represented as yi[n], where n = 1, 2, ..., and Num_sample represents an n$^{th}$ sample value.

The n$^{th}$ sample value on all the m channels is denoted as a column vector $\bar{y}[n]$ :

$$\vec{\mathbf{y}}\left[n\right] = \begin{bmatrix} y_1\left[n\right] \\ y_2\left[n\right] \\ \vdots \\ y_m\left[n\right] \end{bmatrix},$$

$$\mathbf{Q} = \sum_{n=1}^{Num\_sample} \vec{\mathbf{y}}\left[n\right] \times \vec{\mathbf{y}}^T\left[n\right].$$

thereby calculating

The number of nonzero positive eigenvalues of Q is determined as Num_positive_eigenvalue. In practice, the number of eigenvalues that is greater than a very small positive number (such as 1 x 10$^{-8}$) is statisticized. Num_positive_eigenvalue or (2 x Num_band), whichever is smaller, is selected and denoted as Num_valid_eigenvalue. Num_valid_eigenvalue=L largest eigenvalues are selected in the eigenvalues of Q , and denoted as $\xi_j$ (j = 1, 2, ..., Num_valid_eigenvalue). Meanwhile, Num_valid_eigenvalue eigenvectors corresponding to the Num_valid_eigenvalue eigenvalues respectively are selected and denoted as $v_j$(j = 1, 2, ..., Num_valid_eigenvalue).

Multiple y vectors in an orthogonal matching pursuit method are

$$\mathbf{Y} = \begin{bmatrix} \mathbf{v}_1\sqrt{\xi_1} & \mathbf{v}_2\sqrt{\xi_2} & \cdots & \mathbf{v}_L\sqrt{\xi_L} \end{bmatrix} = \begin{bmatrix} \mathbf{y}_1 & \mathbf{y}_2 & \cdots & \mathbf{y}_L \end{bmatrix},$$ and Y = TX, where Y=[$\mathbf{y}_1\ \mathbf{y}_2 \cdots \mathbf{y}_L$], X=[$\mathbf{x}_1\ \mathbf{x}_2 \cdots \mathbf{x}_L$]. That is equivalent to having multiple constraint conditions, that is, $\mathbf{y}_j = \mathbf{T}\mathbf{x}_j$, where j = 1, 2, ..., L.

In all $\mathbf{x}_j$ (j = 1, 2, ..., L), positions of nonzero items are the same. Therefore, in the method given in the reference document [1], for each constraint condition $\mathbf{y}_j = \mathbf{T}\mathbf{x}_j$ (j = 1, 2, ..., L), the orthogonal matching pursuit method is applied to perform signal recovery to calculate the estimation $\hat{\mathbf{x}}_j$ of $\mathbf{x}_j$ , but step 2 in the prior art is modified, so that L constraint conditions $\mathbf{y}_j = \mathbf{T}\mathbf{x}_j$ (j = 1, 2, ..., L) determine the same column (that is, atom).

For each constraint condition $\mathbf{y}_j = \mathbf{T}\mathbf{x}_j$, step 1 in the prior art is applied in the reference document [1], that is, a correlation between a k$^{th}$ residual error and each column in a sensing matrix cleared of k-1 arrays is calculated by using

formula $\mathbf{q}_{\tilde{\Box}(k-1),j} = \mathbf{T}_{\tilde{\Box}(k-1)}^{H}\tilde{\mathbf{y}}_{j}$, where the subscript j represents a residual error $\tilde{\mathbf{y}}$ and correlation $\mathbf{q}_{\Box\tilde{\ }(k-1)}$ corresponding to the constraint condition $\mathbf{y}_j = \mathbf{Tx}_j$; and a sequence number of a column with the maximum correlation value is determined by using formula (1.3b):

$$\rho_k = \underset{i=1}{\overset{\tilde{\Box}(k-1)}{\operatorname{argmax}}} \left( \sum_{j=1}^{L} \left| q_{i,j}^{\Box\tilde{\ }(k-1)} \right|^2 \right) / \left| \delta_i \right|^2 \qquad (1.3b)$$

In the above formula, $q_{i,j}^{\Box\tilde{\ }(k-1)}$ is an $i^{th}$ item of $\mathbf{q}_{\Box\tilde{\ }(k-1),j}$. For ease of description, let

$$\mathbf{Q}_{\tilde{\Box}(k-1)} = \left[ \mathbf{q}_{\tilde{\Box}(k-1),1} \quad \mathbf{q}_{\tilde{\Box}(k-1),2} \quad \cdots \quad \mathbf{q}_{\tilde{\Box}(k-1),L} \right].$$

However, the method disclosed in the reference document is rather complicated in implementing the orthogonal matching pursuit method, and therefore, the method of the present invention may be applied to implement the orthogonal matching pursuit method to reduce the complexity.

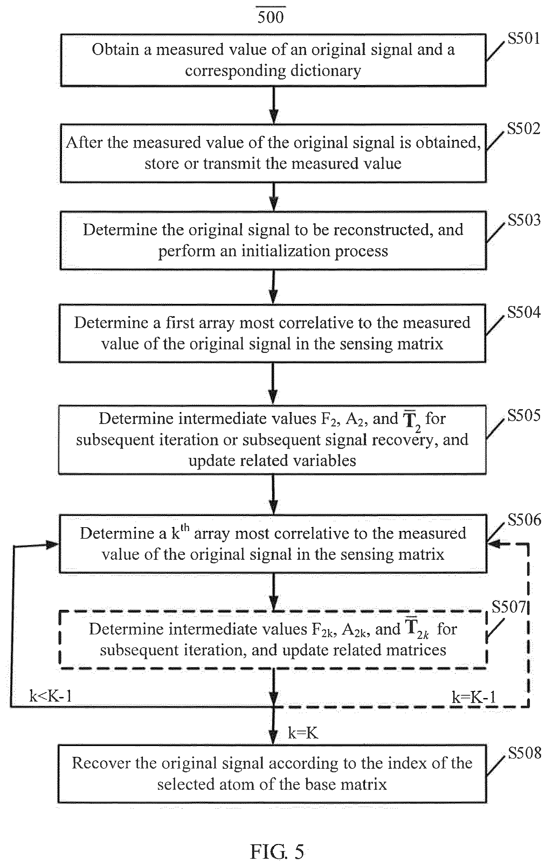

FIG. 5 is a schematic flowchart of a signal reconstruction method 400 according to an embodiment of the present invention. A dictionary **T** with M rows and N columns fulfills: An $i^{th}$ column and an $(N-i+1)^{th}$ column are mutually conjugate (i = 1, 2, ..., N/2), and all items in **Y** = [$\mathbf{y}_1$ $\mathbf{y}_2$ $\cdots$ $\mathbf{y}_L$] are real numbers.

As shown in FIG. 4, the method 400 includes:

S401. Obtain, by using the method disclosed in the reference document [1], a measured value (non-adaptive linear projection) **Y** = [$\mathbf{y}_1$ $\mathbf{y}_2$ $\cdots$ $\mathbf{y}_L$] of an original signal and a corresponding dictionary (that is, sensing matrix) **T**, where the dictionary **T** with M rows and N columns fulfills: An $i^{th}$ column and a $(N-i+1)^{th}$ column are mutually conjugate, and all items in **Y** = [$\mathbf{y}_1$ $\mathbf{y}_2$ $\cdots$ $\mathbf{y}_L$] are real numbers.

S402. After the measured value of the original signal is obtained, store or transmit the measured value.

S403. Determine the original signal to be reconstructed. First, perform an initialization process, where the initialization process may include the following steps:

(1) Set an initial value $\tilde{\mathbf{y}}_j = \mathbf{y}_j$ of a residual error, where j = 1, 2, ..., L, that is, set the initial value of the residual error to be a measured value vector.

(3) Set the sensing matrix **T**, where the sensing matrix is an N×N matrix; and denote the square of the modulus of columns in the sensing matrix **T** as $\boldsymbol{\delta}'_{\tilde{\Box}(0)} = [\left\|\mathbf{t}_{(1)}\right\|_2^2 \quad \left\|\mathbf{t}_{(2)}\right\|_2^2 \quad \cdots \quad \left\|\mathbf{t}_{(N)}\right\|_2^2]$, where $\mathbf{t}_{(i)}$ (i = 1, 2, ..., N) represents the $i^{th}$ column of **T**, and $\left\|\mathbf{t}_{(i)}\right\|_2$ represents the modulus of the vector $\mathbf{t}_{(i)}$; set $\pi_{\Box\tilde{\ }(0)}$, where $\pi_{\Box\tilde{\ }(0)} = [1\ 2\ \cdots\ N]^T$ records a sequence number of each column of the sensing matrix, and is an initial value of an atom sequence number set to be selected. An index of a selected column of a base matrix B is denoted as a column vector $\tau$, and its initial value $\tau_0$ is an empty vector.

(4) Calculate and store a correlation matrix $\Theta = \mathbf{T}^H\mathbf{T}$ of the sensing matrix, or calculate and store off-diagonal items (that is, items that are not on the diagonal) of a correlation matrix $\Theta = \mathbf{T}^H\mathbf{T}$ of the sensing matrix. It should be noted that, because the sensing matrix **T** is generally constant, or at least constant in a long time, it is not necessary to calculate the correlation matrix $\Theta = \mathbf{T}^H\mathbf{T}$ of the sensing matrix on every occasion of reconstructing the original signal. After the correlation matrix $\Theta = \mathbf{T}^H\mathbf{T}$ of the sensing matrix is calculated and stored, the stored correlation matrix $\Theta = \mathbf{T}^H\mathbf{T}$ is reusable in subsequent reconstruction of the original signal and the correlation matrix does not need to be calculated again.

Therefore, in the embodiment of the present invention, the correlation between the $k^{th}$ residual error and the multiple columns in the sensing matrix is determined according to the correlation between the $(k-1)^{th}$ residual error and the multiple columns in the sensing matrix, and a column most correlative to the measured value of the original signal in the sensing matrix is further determined for recovering the signal. In this way, under the premise of ensuring proper recovery of the signal, the amount of calculation for reconstructing the signal can be reduced.

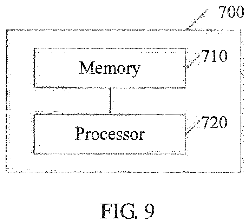

FIG. 9 is a schematic block diagram of a signal reconstruction apparatus 700 according to an embodiment of the present invention. As shown in FIG. 9, the apparatus 700 includes a memory 710 and a processor 720, where the memory 710 stores program codes, and the processor 720 is configured to invoke the program codes to perform the following operations:

determining a correlation between a first residual error and multiple columns in a sensing matrix according to a measured value of an original signal and the sensing matrix, and determining a first array most correlative to the measured value of the original signal in the sensing matrix according to the correlation between the first residual error and the multiple columns in the sensing matrix;

determining a correlation between a $k^{th}$ residual error and the multiple columns in the sensing matrix according to a correlation between a $(k-1)^{th}$ residual error and the multiple columns in the sensing matrix, and determining a $k^{th}$ array most correlative to the measured value of the original signal in the sensing matrix according to the correlation between the $k^{th}$ residual error and the multiple columns in the sensing matrix, where $2 \leq k \leq K$; and

recovering the original signal after determining the $K^{th}$ array most correlative to the measured value of the original signal in the sensing matrix.

The processor 720 is configured to invoke the program codes to specifically perform the following operations: from the correlation between the $(k-1)^{th}$ residual error and the multiple columns in the sensing matrix, subtracting a product of a $(k-1)^{th}$ base difference and a $(k-1)^{th}$ difference coefficient to obtain the correlation between the $k^{th}$ residual error and the multiple columns in the sensing matrix, where the $(k-1)^{th}$ base difference is a vector or a vector set, and the $(k-1)^{th}$ difference coefficient is a scalar or a scalar set or a set of vectors composed of multiple scalars.

The processor 720 is configured to invoke the program codes to specifically perform the following operations:

if k = 2, determining a first base difference;
if k = 3, determining the $(k-1)^{th}$ base difference according to a first base difference;
or
if k ≥ 4, determining the $(k-1)^{th}$ base difference according to first to $(k-2)^{th}$ base differences.

The processor 720 is configured to invoke the program codes to specifically perform the following operations:

determining the first base difference $\overline{\mathbf{t}}_{N-1}$ by using formula $\overline{\mathbf{t}}_1 - \lambda_1 \cdot \mathbf{0}_{(\rho_1)}$; and

determining the $(k-1)^{th}$ base difference by using formula $\overline{\mathbf{t}}_{k-1} = -\lambda_{k-1} \overline{\mathbf{T}}_{k-2} \tilde{\mathbf{u}}_{k-2} + \lambda_{k-1}\theta_{(\rho_{k-1})}$, where $\lambda_1 = \sqrt{1/\theta_{\rho_1,\rho_1}}$, $\theta_{(\rho_1)}$ is a $\rho_1^{th}$ column of $\Theta$, $\theta_{\rho_1,\rho_1}$ is an item in a $\rho_1^{th}$ row and a $\rho_1^{th}$ column in $\Theta$, $\Theta$ is a correlation matrix of the sensing matrix, $\rho_1$ is a sequence number of a column in the sensing matrix, where the column is a column of a first array most correlative to the measured value of the original signal in the sensing matrix, $\overline{\mathbf{T}}_1 = [\overline{\mathbf{t}}_1]$, $\overline{\mathbf{T}}_{k-2} = [\overline{\mathbf{T}}_{k-3}\ \overline{\mathbf{t}}_{k-2}]$, $\lambda_{k-1} = 1/\sqrt{\theta_{\rho_{k-1},\rho_{k-1}} - \tilde{\mathbf{u}}_{k-2}^H \tilde{\mathbf{u}}_{k-2}}$, $\tilde{\mathbf{u}}_{k-2} = \left(\overline{\mathbf{t}}_{(\rho,:)}^H\right)^H$, $\theta_{\rho_{k-1},\rho_{k-1}}$ is an item in a $(\rho_{k-1})^{th}$ row and a $(\rho_{k-1})^{th}$ column in $\Theta$, $\overline{\mathbf{t}}_{(\rho_k,:)}^H$ is a $(\rho_{k-1})^{th}$ row in $\overline{\mathbf{T}}_{k-2}$, and $\rho_{k-1}$ is a sequence number of a column in the sensing matrix, where the column is a column of a $(k-1)^{th}$ array most correlative to the measured value of the original signal in the sensing matrix.

Optionally, the processor 720 is configured to invoke the program codes to specifically perform the following operations:

determining the $k^{th}$ difference coefficient $a_k$ by using formula $a_k = \lambda_k q_{\rho_k}^{k-1}$.

Optionally, the processor 720 is configured to invoke the program codes to specifically perform the following operations:

determining $\mathbf{F}_1$ by using formula $\mathbf{F}_1 = [\lambda_1]$;

if $2 \leq k \leq K$, determining $\mathbf{F}_k$ by using formula $\mathbf{F}_k = \begin{bmatrix} \mathbf{F}_{k-1} & \mathbf{u}_{k-1} \\ \mathbf{0}_{k-1}^T & \lambda_k \end{bmatrix}$, where $\mathbf{u}_{k-1} = -\lambda_k \mathbf{F}_{k-1} \tilde{\mathbf{u}}_{k-1}$; and

recovering the signal according to the $\mathbf{F}_K$.

Optionally, the processor 720 is configured to invoke the program codes to specifically perform the following operations:

determining a weight coefficient column vector $\mathbf{z}_K$ by using formula $\mathbf{z}_K = \mathbf{F}_K \mathbf{a}_K$;
determining x according to the weight coefficient column vector to make $x_{\tau_k} = z_k$, where $z_k$ is a $k^{th}$ item of $\mathbf{z}_K$, and $\tau_k$ is a column in an array most correlative to the measured value of the original signal in the sensing matrix; and obtaining the original signal according to the x.

**Claims**

1.  A signal reconstruction method, comprising:

    determining (S10) a correlation between a first residual error and multiple columns in a sensing matrix according to a measured value of an original signal and the sensing matrix, wherein the first residual error is an initial value of an residual error and is equal to a measured value vector, and determining a first array most correlative to the measured value of the original signal in the sensing matrix according to the correlation between the first residual error and the multiple columns in the sensing matrix;
    determining (S120) a correlation between a $k^{th}$ residual error and the multiple columns in the sensing matrix according to a correlation between a $(k-1)^h$ residual error and the multiple columns in the sensing matrix, and determining a $k^{th}$ array most correlative to the measured value of the original signal in the sensing matrix according to the correlation between the $k^{th}$ residual error and the multiple columns in the sensing matrix, wherein $2 \le k \le K$; and
    recovering (S130) the original signal after determining a $K^{th}$ array most correlative to the measured value of the original signal in the sensing matrix, **characterized in that**:
    the determining a correlation between a $k^{th}$ residual error and the multiple columns in the sensing matrix according to a correlation between a $(k-1)^{th}$ residual error and the multiple columns in the sensing matrix comprises:
    from the correlation between the $(k-1)^h$ residual error and the multiple columns in the sensing matrix, subtracting a product of a $(k-1)^h$ base difference and a $(k-1)^h$ difference coefficient to obtain the correlation between the $k^{th}$ residual error and the multiple columns in the sensing matrix, wherein the determining a correlation between a $k^{th}$ residual error and the multiple columns in the sensing matrix further comprises:

    if k = 2, determining a first base difference;
    if k = 3, determining the $(k-1)^h$ base difference according to a first base difference; or
    if $k \ge 4$, determining the $(k-1)^h$ base difference according to first to $(k-2)^{th}$ base differences, wherein the determining a first base difference comprises: determining the first base difference $\overline{\mathbf{t}}_{N-1}$ by using formula $\overline{\mathbf{t}}_1 = \lambda_1 \cdot \theta_{(\rho 1)}$;

    wherein $\lambda_1 = \sqrt{1 / \theta_{\rho_1, \rho_1}}$, $\theta_{(\rho 1)}$ is a $\rho_1{}^{th}$ column of $\Theta$, $\theta_{\rho_1, \rho_1}$ is an item in a $\rho_1{}^{th}$ row and a $\rho_1{}^{th}$ column in $\Theta$, $\Theta$ is a correlation matrix of the sensing matrix, $\rho_1$ is a sequence number of a column in the sensing matrix, wherein the column is a column of a first array most correlative to the measured value of the original signal in the sensing matrix, $\overline{\mathbf{T}}_1 = [\overline{\mathbf{t}}_1]$

2.  The method according to claim 1, wherein: the determining the $(k-1)^h$ base difference comprises: determining the $(k-1)^h$ base difference by using formula $\overline{\mathbf{t}}_{k-1} = -\lambda_{k-1}\overline{\mathbf{T}}_{k-2}\tilde{\mathbf{u}}_{k-2} + \lambda_{k-1}\theta_{(\rho_{k-1})}$, wherein $\overline{\mathbf{T}}_{k-2} = [\overline{\mathbf{T}}_{k-3} \ \overline{\mathbf{t}}_{k-2}]$,

    $\lambda_{k-1} = 1 / \sqrt{\theta_{\rho_{k-1}, \rho_{k-1}} - \tilde{\mathbf{u}}_{k-2}^H \tilde{\mathbf{u}}_{k-2}}$, $\tilde{\mathbf{u}}_{k-2} = \left(\overline{\mathbf{t}}_{(\rho,:)}^H\right)^H$, $\theta_{\rho_{k-1}, \rho_{k-1}}$ is an item in a $\rho_{k-1}{}^{th}$ row and a $\rho_{k-1}{}^{th}$

    column in $\Theta$, $\overline{\mathbf{t}}_{(\rho_k, :)}^H$ is a $(\rho_{k-1})^{th}$ row in $\overline{\mathbf{T}}_{k-2}$, and $\rho_{k-1}$ is a sequence number of a column in the sensing matrix, wherein the column is a column of a $(k-1)^{th}$ array most correlative to the measured value of the original signal in the sensing matrix.

3. The method according to claim 2, wherein: before the from the correlation between the (k-1)[h] residual error and the multiple columns in the sensing matrix, subtracting a product of a (k-1)[h] base difference and a (k-1)[h] difference coefficient to obtain the correlation between the kth residual error and the multiple columns in the sensing matrix, the determining a correlation between a kth residual error and the multiple columns in the sensing matrix further comprises:

   determining a kth difference coefficient $a_k$ by using formula $a_k = \lambda_k q_{\rho_k}^{k-1}$.

4. The method according to claim 2 or 3, wherein the method further comprises:

   determining $\mathbf{F}_1$ by using formula $\mathbf{F}_1 = [\lambda_1]$ ; and

   if $2 \leq k \leq K$, determining $\mathbf{F}_k$ by using formula $\mathbf{F}_k = \begin{bmatrix} \mathbf{F}_{k-1} & \mathbf{u}_{k-1} \\ \mathbf{0}_{k-1}^T & \lambda_k \end{bmatrix}$ , wherein $\mathbf{u}_{k-1} = -\lambda_k \mathbf{F}_{k-1}\tilde{\mathbf{u}}_{k-1}$; and
   the recovering the original signal of a received signal after determining a Kth array of the base matrix comprises: recovering the signal according to the $\mathbf{F}_K$.

5. The method according to claim 4, wherein: the recovering the signal according to the $\mathbf{F}_K$ comprises: determining a weight coefficient column vector $\mathbf{z}_K$ by using formula $\mathbf{z}_K = \mathbf{F}_K \mathbf{a}_K$ :

   determining x according to the weight coefficient column vector to make $\hat{x}_{\tau_k} = z_k$,
   wherein $z_k$ is a kth item of $\mathbf{z}_K$, and $\tau_k$ is a column in an array most correlative to the measured value of the original signal in the sensing matrix; and
   obtaining the original signal according to the x.

6. The method according to claim 1, wherein:

   the determining a first base difference comprises: determining a first column and a second column of $\overline{\mathbf{T}}_2$ as the first base difference; and
   the determining the (k-1)th base difference comprises: determining a (2k-3)th column and a (2k-2)th column of $\overline{\mathbf{T}}_{2k-2}$ as the (k-1)th base difference, wherein

   $$\overline{\mathbf{T}}_2 = \left[ \lambda_1 \boldsymbol{\theta}_{(\rho_1)} \quad f_{1,2}\boldsymbol{\theta}_{(\rho_1)} + \lambda_2 \times \mathrm{flipud}\left(\boldsymbol{\theta}_{(\rho_1)}^*\right) \right] ,$$

   $$\overline{\mathbf{T}}_{2k-2} = \left[ \overline{\mathbf{T}}_{2k-4} \quad \lambda_{2k-3}\tilde{\mathbf{t}}_k \quad \left( f_{2k-3,2k-2}\tilde{\mathbf{t}}_{k-1} + \lambda_{2k-2} \times \mathrm{flipud}\left(\tilde{\mathbf{t}}_{k-1}^*\right) \right) \right] ,$$

   $$\lambda_1 = \sqrt{1/\theta_{\rho_1,\rho_1}} , \quad \theta_{\rho_1,\rho_1}$$

   represents an item in a $\rho_1$[th] row and a $\rho_1$[th] column in the sensing matrix $\Theta$, $\theta_{(\rho_1)}$ is the $\rho_1$[th] column in the sensing matrix $\Theta$, $f_{1,2} = -\lambda_2 \lambda_1 u_1''$ , $\lambda_2 = 1/\sqrt{\theta_{\rho_1,\rho_1} - \left(u_1''\right)^* u_1''}$ , $u_1'' = \lambda_1 \times \theta_{\rho_1,N-\rho_1+1}$ , $\theta_{\rho_1,N-\rho_1+1}$ represents an item in the $\rho_1$[th] row and a (N - $\rho_1$ + 1)th column in the sensing matrix $\Theta$, $\mathbf{q}_{\rho_1,:}^H$ is the $\rho_1$[th] row in $\mathbf{Q}$, $\mathbf{Q}$ is a matrix composed of correlations between the first residual error and the multiple columns in the sensing matrix, $\lambda_{2k-3} = 1/\sqrt{\theta_{\rho_{k-1},\rho_{k-1}} - \tilde{\mathbf{u}}_{2k-4}'^H \tilde{\mathbf{u}}_{2k-4}'}$ , $\tilde{\mathbf{u}}_{2k-4}' = \left(\overline{\mathbf{T}}_{2k-4}(\overline{\rho}_{k-1},:)\right)^H$ , $\overline{\mathbf{T}}_{2k-4}(\overline{\rho}_{k-1},:)$ repre-

sents a $(\overline{\rho}_{k-1})^{th}$ row in the matrix $\overline{\mathbf{T}}_{2k-4}$, $f_{2k-3,2k-2} = -\lambda_{2k-2}\lambda_{2k-3}\tilde{u}''_{2k-3}$ ,

$$\lambda_{2k-2} = 1 / \sqrt{1 / \lambda_{2k-3}^2 - |\tilde{u}''_{2k-3}|^2} \qquad \tilde{u}''_{2k-3} = \lambda_{2k-3}\left(\theta_{\overline{\rho}_{k-1},\rho_{k-1}} - \overline{\mathbf{T}}_{2k-4}(\overline{\rho}_{k-1},:) \times \tilde{\mathbf{u}}'_{2k-4}\right)^* ,$$

$$\tilde{\mathbf{t}}_{k-1} = \theta_{(\rho_{k-1})} - \overline{\mathbf{T}}_{2k-4}\tilde{\mathbf{u}}'_{2k-4} ,$$ and $\theta_{(\rho_{k-1})}$ is a $\rho_{k-1}{}^{th}$ column in the matrix $\Theta$.

7. A signal reconstruction apparatus (600), comprising:

a first determining unit (610), configured to determine a correlation between a first residual error and multiple columns in a sensing matrix according to a measured value of an original signal and the sensing matrix, and determine a first array most correlative to the measured value of the original signal in the sensing matrix according to the correlation between the first residual error and the multiple columns in the sensing matrix, wherein the first residual error is an initial value of an residual error and is equal to a measured value vector;
a second determining unit (620), configured to determine a correlation between a $k^{th}$ residual error and the multiple columns in the sensing matrix according to a correlation between a $(k-1)^{th}$ residual error and the multiple columns in the sensing matrix, and determine a $k^{th}$ array most correlative to the measured value of the original signal in the sensing matrix according to the correlation between the $k^{th}$ residual error and the multiple columns in the sensing matrix, wherein $2 \le k \le K$; and
a recovering unit (630), configured to recover the original signal after the second determining unit determines a $K^{th}$ array most correlative to the measured value of the original signal in the sensing matrix; **characterized in that**
the second determining unit is specifically configured to:

if k = 2, determine a first base difference;
if k = 3, determine the $(k-1)^{h}$ base difference according to a first base difference; or
if $k \ge 4$, determine the $(k-1)^{h}$ base difference according to first to $(k-2)^{th}$ base differences, wherein the second determining unit is specifically configured to: determine the first base difference $\overline{\mathbf{t}}_{N-1}$ by using formula $\overline{\mathbf{t}}_1 = \lambda_1 \cdot \theta_{(\rho_1)}$;
wherein $\lambda_1 = \sqrt{1 / \theta_{\rho_1,\rho_1}}$ , $\theta_{(\rho_1)}$ is a $\rho_1{}^{th}$ column of $\Theta$, $\theta_{\rho_1,\rho_1}$ is an item in a $\rho_1{}^{th}$ row and a $\rho_1{}^{th}$ column in $\Theta$, $\Theta$ is a correlation matrix of the sensing matrix, $\rho_1$ is a sequence number of a column in the sensing matrix, wherein the column is a column of a first array most correlative to the measured value of the original signal in the sensing matrix, $\overline{\mathbf{T}}_1 = [\overline{\mathbf{t}}_1]$

8. The apparatus according to claim 7, wherein the second determining unit is specifically configured to:
determine the $(k-1)^{th}$ base difference by using formula $\overline{\mathbf{t}}_{k-1} = -\lambda_{k-1}\overline{\mathbf{T}}_{k-2}\tilde{\mathbf{u}}_{k-2} + \lambda_{k-1}\theta_{(\rho_{k-1})}$, wherein $\overline{\mathbf{T}}_{k-2} = [\overline{\mathbf{T}}_{k-3}\ \overline{\mathbf{t}}_{k-2}]$,

$$\lambda_{k-1} = 1 / \sqrt{\theta_{\rho_{k-1},\rho_{k-1}} - \tilde{\mathbf{u}}_{k-2}^H \tilde{\mathbf{u}}_{k-2}} , \quad \tilde{\mathbf{u}}_{k-2} = \left(\overline{\mathbf{t}}_{(\rho,:)}^H\right)^H ,$$ $\theta_{\rho_{k-1},\rho_{k-1}}$ is an item in a $(\rho_{k-1})^{th}$ row and a $(\rho_{k-1})^{th}$ column in $\Theta$, $\overline{\mathbf{t}}_{(\rho_k:)}^H$ is a $(\rho_{k-1})^{th}$ row in $\overline{\mathbf{T}}_{k-2}$, and $\rho_{k-1}$ is a sequence number of a column in the sensing matrix, wherein the column is a column of a $(k-1)^{h}$ array most correlative to the measured value of the original signal in the sensing matrix.

9. The apparatus according to claim 8, wherein the second determining unit is further configured to:
determine the $k^{th}$ difference coefficient $a_k$ by using formula $a_k = \lambda_k q_{\rho_k}^{k-1}$ .

10. The apparatus according to claim 8 or 9, wherein the apparatus further comprises:

a third determining unit, configured to: determine $\mathbf{F}_1$ by using formula $\mathbf{F}_1 = [\lambda_1]$, and if $2 \le k \le K$, determine $\mathbf{F}_k$

$$\mathbf{F}_k = \begin{bmatrix} \mathbf{F}_{k-1} & \mathbf{u}_{k-1} \\ \mathbf{0}_{k-1}^T & \lambda_k \end{bmatrix} ,$$

by using formula                    wherein $\mathbf{u}_{k-1} = -\lambda_k \mathbf{F}_{k-1} \mathbf{u}_{k-1}$; and

the recovering unit is specifically configured to:

recover the signal according to the $\mathbf{F}_K$.

11. The apparatus according to claim 10, wherein the recovering unit is specifically configured to:

determine a weight coefficient column vector $\mathbf{z}_K$ by using formula $\mathbf{z}_K = \mathbf{F}_K \mathbf{a}_K$ ;

determine x according to the weight coefficient column vector to make $x_{\tau k} = z_k$, wherein $z_k$ is a k$^{th}$ item of $\mathbf{z}_K$, and $\tau_k$ is a column in an array most correlative to the measured value of the original signal in the sensing matrix; and

obtain the original signal according to the x.

**Patentansprüche**

1. Signalrekonstruktionsverfahren, umfassend:

Bestimmen (S110) einer Korrelation zwischen einem ersten Restfehler und mehreren Spalten in einer Erfassungsmatrix gemäß einem gemessenen Wert eines ursprünglichen Signals und der Erfassungsmatrix, wobei der erste Restfehler ein Anfangswert eines Restfehlers ist und gleich einem gemessenen Wertevektor ist, und Bestimmen eines ersten Arrays, das zu dem gemessenen Wert des ursprünglichen Signals in der Erfassungsmatrix am meisten korrelativ ist, gemäß der Korrelation zwischen dem ersten Restfehler und den mehreren Spalten in der Erfassungsmatrix;

Bestimmen (S120) einer Korrelation zwischen einem k-ten Restfehler und den mehreren Spalten in der Erfassungsmatrix gemäß einer Korrelation zwischen einem (k-1)-ten Restfehler und den mehreren Spalten in einer Erfassungsmatrix, und Bestimmen eines k-ten Arrays, das zu dem gemessenen Wert des ursprünglichen Signals in der Erfassungsmatrix am meisten korrelativ ist, gemäß der Korrelation zwischen dem k-ten Restfehler und den mehreren Spalten in der Erfassungsmatrix, wobei $2 \le k \le K$; und

Wiederherstellen (S130) des ursprünglichen Signals nach der Bestimmung eines K-ten Arrays, das zu dem gemessenen Wert des ursprünglichen Signals in der Erfassungsmatrix am meisten korrelativ ist, **dadurch gekennzeichnet, dass**:

das Bestimmen einer Korrelation zwischen einem k-ten Restfehler und den mehreren Spalten in der Erfassungsmatrix gemäß einer Korrelation zwischen einem (k-1)-ten Restfehler und den mehreren Spalten in einer Erfassungsmatrix Folgendes umfasst:

aus der Korrelation zwischen dem (k-1)-ten Restfehler und den mehreren Spalten in der Erfassungsmatrix, Subtrahieren eines Produkts einer (k-1)-ten Basisdifferenz und eines (k-1)-ten Differenzkoeffizienten, um die Korrelation zwischen dem k-ten Restfehler und den mehreren Spalten in der Erfassungsmatrix zu erhalten,

wobei das Bestimmen einer Korrelation zwischen einem k-ten Restfehler und den mehreren Spalten in der Erfassungsmatrix ferner Folgendes umfasst:

falls k = 2, Bestimmen einer ersten Basisdifferenz;

falls k = 3, Bestimmen der (k-1)-ten Basisdifferenz gemäß einer ersten Basisdifferenz;

oder

falls $k \ge 4$, Bestimmen der (k-1)-ten Basisdifferenz gemäß der ersten bis (k-2)-ten Basisdifferenz, wobei das Bestimmen einer ersten Basisdifferenz Folgendes umfasst:

Bestimmen der ersten Basisdifferenz $\overline{t}_{N-1}$ unter Verwendung der Formel $\overline{\mathbf{t}}_1 = \lambda_1 \cdot \theta_{(\rho_1)}$;

wobei

$$\lambda_1 = \sqrt{1/\theta_{\rho_1,\rho_1}} ,$$ $\theta_{(\rho_1)}$ eine $\rho_1$-te Spalte von Θ ist, $\theta_{\rho_1,\rho_1}$ ein Element in einer $\rho_1$-ten Zeile und einer $\rho_1$-ten Spalte in Θ ist, Θ eine Korrelationsmatrix der Erfassungsmatrix ist, $\rho_1$ eine Sequenz-

nummer einer Spalte in der Erfassungsmatrix ist, wobei die Spalte eine Spalte eines ersten Arrays ist, das zu dem gemessenen Wert des ursprünglichen Signals in der Erfassungsmatrix am meisten korrelativ ist, $\overline{T}_1 = [\overline{t}_1]$.

2. Verfahren nach Anspruch 1, wobei:
das Bestimmen der (k-1)-ten Basisdifferenz Folgendes umfasst: Bestimmen der (k-1)-ten Basisdifferenz unter Verwendung der Formel

$$\overline{t}_{k-1} = -\lambda_{k-1}\overline{T}_{k-2}\tilde{u}_{k-2} + \lambda_{k-1}\theta_{(\rho_{k-1})},$$

wobei

$$\overline{T}_{k-2} = [\overline{T}_{k-3} \quad \overline{t}_{k-2}],$$

$$\lambda_{k-1} = 1/\sqrt{\theta_{\rho_{k-1},\rho_{k-1}} - \tilde{u}_{k-2}^{H}\tilde{u}_{k-2}}, \; \tilde{u}_{k-2} = \left(\overline{t}_{p,:}^{H}\right)^{H}, \; \theta_{\rho_{k-1},\rho_{k-1}}$$

ein Element in einer $(\rho_{k-1})$-ten Zeile und einer $(\rho_{k-1})$-ten Spalte in $\Theta$ ist, $\overline{t}_{\rho_{k,:}}^{H}$ eine $(\rho_{k-1})$-te Zeile in $\overline{T}_{k-2}$ ist und $\rho_{k-1}$ eine Sequenznummer einer Spalte in der Erfassungsmatrix ist, wobei die Spalte eine Spalte eines (k-1)-ten Arrays ist, das zu dem gemessenen Wert des ursprünglichen Signals in der Erfassungsmatrix am meisten korrelativ ist.

3. Verfahren nach Anspruch 2, wobei: vor dem, aus der Korrelation zwischen dem (k-1)-ten Restfehler und den mehreren Spalten in der Erfassungsmatrix, Subtrahieren eines Produkts einer (k-1)-ten Basisdifferenz und eines (k-1)-ten Differenzkoeffizienten, um die Korrelation zwischen dem k-ten Restfehler und den mehreren Spalten in der Erfassungsmatrix zu erhalten, das Bestimmen einer Korrelation zwischen einem k-ten Restfehler und den mehreren Spalten in der Erfassungsmatrix ferner Folgendes umfasst:

Bestimmen eines k-ten Differenzkoeffizienten $a_k$ unter Verwendung der Formel $a_k = \lambda_k q_{\rho_k}^{k-1}$.

4. Verfahren nach Anspruch 2 oder 3, wobei das Verfahren ferner Folgendes umfasst:

Bestimmen von $\mathbf{F}_1$ unter Verwendung der Formel $\mathbf{F}_1 = [\lambda_1]$; und
falls $2 \le k \le K$, Bestimmen von $F_k$ unter Verwendung der Formel

$$F_k = \begin{bmatrix} F_{k-1} & u_{k-1} \\ 0_{k-1}^{T} & \lambda_k \end{bmatrix},$$

wobei

$$u_{k-1} = -\lambda_k F_{k-1}\tilde{u}_{k-1};$$

und
wobei das Wiederherstellen des ursprünglichen Signals eines empfangenen Signals nach dem Bestimmen eines K-ten Arrays der Basismatrix Folgendes umfasst:
Wiederherstellen des Signals gemäß dem $\mathbf{F}_K$.

5. Verfahren nach Anspruch 4, wobei: das Wiederherstellen des Signals gemäß dem $\mathbf{F}_K$ Folgendes umfasst:
Bestimmen eines Gewichtungskoeffizienten-Spaltenvektors $\mathbf{z}_K$ unter Verwendung der Formel $\mathbf{z}_K = \mathbf{F}_K\mathbf{a}_K$:

Bestimmen von x gemäß dem Gewichtungskoeffizienten-Spaltenvektor, um $\hat{\mathbf{x}}_{\tau k} = \mathbf{z}_k$ zu machen,
wobei $\mathbf{z}_k$ ein k-tes Element von $\mathbf{z}_K$ ist und $\tau_k$ eine Spalte in einem Array ist, das zu dem gemessenen Wert des ursprünglichen Signals in der Erfassungsmatrix am meisten korrelativ ist; und
Erhalten des ursprünglichen Signals gemäß dem x.

6. Verfahren nach Anspruch 1, wobei:

das Bestimmen einer ersten Basisdifferenz Folgendes umfasst: Bestimmen einer ersten Spalte und einer zweiten Spalte von $\overline{\mathrm{T}}_2$ als die erste Basisdifferenz; und

das Bestimmen der (k-1)-ten Basisdifferenz Folgendes umfasst: Bestimmen einer (2k-3)-ten Spalte und einer (2k-2)-ten Spalte von $\overline{\mathrm{T}}_{2k-2}$ als die (k-1)-te Basisdifferenz,

wobei

$$\mathbf{T}_2 = \begin{bmatrix} \lambda_1 \theta_{(\rho_1)} & f_{1,2}\theta_{(\rho_1)} + \lambda_2 \times \mathrm{flipud}\big(\theta^*_{(\rho_1)}\big) \end{bmatrix},$$

$$\mathbf{T}_{2k-2} = \begin{bmatrix} \mathbf{T}_{2k-4} & \lambda_{2k-3}\tilde{\mathfrak{t}}_k & \big(f_{2k-3,2k-2}\tilde{\mathfrak{t}}_{k-1} + \lambda_{2k-2} \times \mathrm{flipud}(\tilde{\mathfrak{t}}^*_{k-1})\big) \end{bmatrix},$$

$$\lambda_1 = \sqrt{1/\theta_{\rho_1,\rho_1}}, \ \theta_{\rho_1,\rho_1}$$

ein Element in einer $\rho_1$-ten Zeile und einer $\rho_1$-ten Spalte in der Erfassungsmatrix $\Theta$ repräsentiert, $\theta_{(\rho_1)}$ die $\rho_1$-te

Spalte in der Erfassungsmatrix $\Theta$ ist, $f_{1,2} = -\lambda_2\lambda_1 u''_1$, $\lambda_2 = 1/\sqrt{\theta_{\rho_1,\rho_1} - (u''_1)^* u''_1}$,

$u''_1 = \lambda_1 \times \theta_{\rho_1,N-\rho_1+1}$, $\theta_{\rho_1,N\text{-}\rho_1+1}$ ein Element in der $\rho_1$-ten Zeile und einer ($N$ - $\rho_1$ + 1)-ten Spalte in der

Erfassungsmatrix $\Theta$ repräsentiert, $\mathbf{q}^H_{\rho_{1,:}}$ die $\rho_1$-te Zeile in $\mathbf{Q}$ ist, $\mathbf{Q}$ eine Matrix ist, die aus Korrelationen zwischen dem ersten Restfehler und den mehreren Spalten in der Erfassungsmatrix besteht

$$\lambda_{2k-3} = 1/\sqrt{\theta_{\rho_{k-1},\rho_{k-1}} - \tilde{\mathrm{u}}'^H_{2k-4}\tilde{\mathrm{u}}'_{2k-4}}, \ \tilde{\mathrm{u}}'_{2k-4} = \big(\overline{\mathrm{T}}_{2k-4}(\bar{\rho}_{k-1},:)\big)^H, \ \overline{\mathrm{T}}_{2k-4}(\bar{\rho}_{k-1},:)$$

eine $(\overline{\rho_{k-1}})$-te Zeile in der Matrix $\overline{\mathrm{T}}_{2k-4}$ repräsentiert,

$$f_{2k-3,2k-2} = -\lambda_{2k-2}\lambda_{2k-3}\tilde{u}''_{2k-3},$$

$$\lambda_{2k-2} = 1/\sqrt{1/\lambda^2_{2k-3} - |\tilde{u}''_{2k-3}|^2},$$

$$\tilde{u}''_{2k-3} = \lambda_{2k-3}\big(\theta_{\bar{\rho}_{k-1},\rho_{k-1}} - \overline{\mathrm{T}}_{2k-4}(\bar{\rho}_{k-1},:) \times \tilde{\mathrm{u}}'_{2k-4}\big)^*,$$

$$\tilde{\mathfrak{t}}_{k-1} = \theta_{(\rho_{k-1})} - \overline{\mathrm{T}}_{2k-4}\tilde{\mathrm{u}}'_{2k-4},$$

und $\theta_{(\rho k-1)}$ eine $(\rho_{k-1})$-te Spalte in der Matrix $\Theta$ ist.

7. Signalrekonstruktionsvorrichtung (600), umfassend:

eine erste Bestimmungseinheit (610), die ausgelegt ist zum Bestimmen einer Korrelation zwischen einem ersten Restfehler und mehreren Spalten in einer Erfassungsmatrix gemäß einem gemessenen Wert eines ursprünglichen Signals und der Erfassungsmatrix, und zum Bestimmen eines ersten Arrays, das zu dem gemessenen Wert des ursprünglichen Signals in der Erfassungsmatrix am meisten korrelativ ist, gemäß der Korrelation zwischen dem ersten Restfehler und den mehreren Spalten in der Erfassungsmatrix, wobei der erste Restfehler ein Anfangswert eines Restfehlers ist und gleich einem gemessenen Wertevektor ist;

eine zweite Bestimmungseinheit (620), die ausgelegt ist zum Bestimmen einer Korrelation zwischen einem k-ten Restfehler und den mehreren Spalten in der Erfassungsmatrix gemäß einer Korrelation zwischen einem (k-1)-ten Restfehler und den mehreren Spalten in der Erfassungsmatrix, und zum Bestimmen eines k-ten Arrays, das zu dem gemessenen Wert des ursprünglichen Signals in der Erfassungsmatrix am meisten korrelativ ist, gemäß der Korrelation zwischen dem k-ten Restfehler und den mehreren Spalten in der Erfassungsmatrix, wobei $2 \leq k \leq K$; und

eine Wiederherstellungseinheit (630), die ausgelegt ist zum Wiederherstellen des ursprünglichen Signals nachdem die zweite Bestimmungseinheit ein K-tes Array bestimmt, das zu dem gemessenen Wert des ursprünglichen Signals in der Erfassungsmatrix am meisten korrelativ ist, **dadurch gekennzeichnet, dass**:

die zweite Bestimmungseinheit spezifisch ausgelegt ist zum
falls k = 2, Bestimmen einer ersten Basisdifferenz;
falls k = 3, Bestimmen der (k-1)-ten Basisdifferenz gemäß einer ersten Basisdifferenz; oder
falls $k \geq 4$, Bestimmen der (k-1)-ten Basisdifferenz gemäß der ersten bis (k-2)-ten Basisdifferenz, wobei die zweite Bestimmungseinheit spezifisch ausgelegt ist zum:

Bestimmen der ersten Basisdifferenz
$\bar{t}_{N-1}$ unter Verwendung der Formel $\bar{t}_1 = \lambda_1 \cdot \theta_{(\rho_1)}$;

wobei $\lambda_1 = \sqrt{1/\theta_{\rho_1,\rho_1}}$, $\theta_{(\rho_1)}$ eine $\rho_1$-te Spalte von $\Theta$ ist, $\theta_{\rho_1,\rho_1}$ ein Element in einer $\rho_1$-ten Zeile und einer $\rho_1$-ten Spalte in $\Theta$ ist, $\Theta$ eine Korrelationsmatrix der Erfassungsmatrix ist, $\rho_1$ eine Sequenznummer einer Spalte in der Erfassungsmatrix ist, wobei die Spalte eine Spalte eines ersten Arrays ist, das zu dem gemessenen Wert des ursprünglichen Signals in der Erfassungsmatrix am meisten korrelativ ist, $\overline{T}_1 = [\bar{t}_1]$.

8. Vorrichtung nach Anspruch 7, wobei die zweite Bestimmungseinheit spezifisch ausgelegt ist zum Bestimmen der (k-1)-ten Basisdifferenz unter Verwendung der Formel

$$\bar{t}_{k-1} = -\lambda_{k-1} \overline{T}_{k-2} \tilde{u}_{k-2} + \lambda_{k-1} \theta_{(\rho_{k-1})},$$

wobei

$$\mathbf{T}_{k-2} = [\overline{T}_{k-3} \quad \bar{t}_{k-2}], \lambda_{k-1} = 1/\sqrt{\theta_{\rho_{k-1},\rho_{k-1}} - \tilde{u}_{k-2}^H \tilde{u}_{k-2}}, \tilde{u}_{k-2} = \left(\bar{t}_{p,:}^H\right)^H,$$

$\theta_{\rho_{k-1},\rho_{k-1}}$ ein Element in einer $(\rho_{k-1})$-ten Zeile und einer $(\rho_{k-1})$-ten Spalte in $\Theta$ ist, $\bar{t}_{\rho_k,:}^H$ eine $(\rho_{k-1})$-te Zeile in $\overline{T}_{k-2}$ ist und $\rho_{k-1}$ eine Sequenznummer einer Spalte in der Erfassungsmatrix ist, wobei die Spalte eine Spalte eines (k-1)-ten Arrays ist, das zu dem gemessenen Wert des ursprünglichen Signals in der Erfassungsmatrix am meisten korrelativ ist.

9. Vorrichtung nach Anspruch 8, wobei die zweite Bestimmungseinheit ferner ausgelegt ist zum Bestimmen des k-ten Differenzkoeffizienten $a_k$ unter Verwendung der Formel

$$a_k = \lambda_k q_{\rho_k}^{k-1}.$$

10. Vorrichtung nach Anspruch 8 oder 9, wobei die Vorrichtung ferner Folgendes umfasst:
eine dritte Bestimmungseinheit, die ausgelegt ist zum Bestimmen von $\mathbf{F}_1$ unter Verwendung der Formel $F_1 = [\lambda_1]$,

und falls $2 \leq k \leq K$, Bestimmen von $F_k$ unter Verwendung der Formel $\overline{F}_k = \begin{bmatrix} \overline{F}_{k-1} & u_{k-1} \\ \mathbf{0}_{k-1}^T & \lambda_k \end{bmatrix}$, wobei

$$u_{k-1} = -\lambda_k F_{k-1} \tilde{u}_{k-1};$$

und wobei die Wiederherstellungseinheit spezifisch ausgelegt ist zum Wiederherstellen des Signals gemäß dem $F_K$.

11. Vorrichtung nach Anspruch 10, wobei die Wiederherstellungseinheit spezifisch ausgelegt ist zum Bestimmen eines Gewichtungskoeffizienten-Spaltenvektors $z_K$ unter Verwendung der Formel $z_K = F_K a_K$:

Bestimmen von x gemäß dem Gewichtungskoeffizienten-Spaltenvektor, um $\hat{x}_{\tau k} = z_k$ zu machen, wobei $z_k$ ein k-tes Element von $z_K$ ist und $\tau_k$ eine Spalte in einem Array ist, das zu dem gemessenen Wert des ursprünglichen Signals in der Erfassungsmatrix am meisten korrelativ ist; und Erhalten des ursprünglichen Signals gemäß dem x.

## Revendications

1. Procédé de reconstruction de signal, comprenant les étapes suivantes :

déterminer (S110) une corrélation entre une première erreur résiduelle et des colonnes multiples dans une matrice de détection selon une valeur mesurée d'un signal original et la matrice de détection, où la première erreur résiduelle est une valeur initiale d'une erreur résiduelle et est égale à un vecteur de valeur mesurée, et déterminer un premier tableau le plus corrélé à la valeur mesurée du signal original dans la matrice de détection selon la corrélation entre la première erreur résiduelle et les colonnes multiples dans la matrice de détection ;
déterminer (S120) une corrélation entre une k$^{\text{ième}}$ erreur résiduelle et les colonnes multiples dans la matrice de détection en fonction d'une corrélation entre une (k-1)$^{\text{ième}}$ erreur résiduelle et les colonnes multiples dans la matrice de détection, et déterminer un k$^{\text{ième}}$ tableau le plus corrélé à la valeur mesurée du signal original dans la matrice de détection en fonction de la corrélation entre la k$^{\text{ième}}$ erreur résiduelle et les colonnes multiples dans la matrice de détection, où $2 \leq k \leq K$ ; et
récupérer (S 130) le signal original après avoir déterminé un K$^{\text{ième}}$ tableau le plus corrélé à la valeur mesurée du signal original dans la matrice de détection, **caractérisé en ce que** :
la détermination d'une corrélation entre une k$^{\text{ième}}$ erreur résiduelle et les colonnes multiples dans la matrice de détection en fonction d'une corrélation entre une (k-1)$^{\text{ième}}$ erreur résiduelle et les colonnes multiples dans la matrice de détection comprend l'étape suivante :
soustraire, de la corrélation entre la (k-1)$^{\text{ième}}$ erreur résiduelle et les colonnes multiples dans la matrice de détection, un produit d'une (k-1)$^{\text{ième}}$ différence de base et d'un (k-1)$^{\text{ième}}$ coefficient de différence pour obtenir la corrélation entre la k$^{\text{ième}}$ erreur résiduelle et les colonnes multiples dans la matrice de détection,
où
la détermination d'une corrélation entre une k$^{\text{ième}}$ erreur résiduelle et les colonnes multiples dans la matrice de détection comprend en outre les étapes suivantes :

si k = 2, déterminer une première différence de base ;
si k = 3, déterminer la (k-1)$^{\text{ième}}$ différence de base en fonction d'une première différence de base ; ou
si $k \geq 4$, déterminer la (k-1)$^{\text{ième}}$ différence de base en fonction des première à (k-2)$^{\text{ième}}$ différences de base, où la détermination d'une première différence de base comprend de déterminer la première différence de base $\overline{t}_{N-1}$ en utilisant la formule $\overline{t}_1 = \lambda_1 \cdot \theta_{(\rho 1)}$ ; où :

$\lambda_1 = \sqrt{1/\theta_{\rho 1, \rho 1}}$, $\theta_{(\rho 1)}$ est une $\rho_1^{\text{ième}}$ colonne de $\Theta$, $\theta_{\rho 1, \rho 1}$ est un élément dans une $\rho_1^{\text{ième}}$ ligne et une $\rho_1^{\text{ième}}$ colonne dans $\Theta$, $\Theta$ est une matrice de corrélation de la matrice de détection, $\rho_1$ est un numéro de séquence d'une colonne dans la matrice de détection, où la colonne est une colonne d'un premier tableau le plus corrélé à la valeur mesurée du signal original dans la matrice de détection, $\overline{T}_1 = [\overline{t}_1]$.

**2.** Procédé selon la revendication 1, dans lequel :
la détermination de la (k-1)$^{ième}$ différence de base comprend l'étape suivante :
déterminer la (k-1)$^{ième}$ différence de base en utilisant la formule $\bar{t}_{k-1} = -\lambda_{k-1}\overline{T}_{k-2}\tilde{u}_{k-2} + \lambda_{k-1}\theta_{(\rho k-1)}$, où

$$\overline{T}_{k-2} = [\overline{T}_{k-3} \ \bar{t}_{k-2}], \qquad \lambda_{k-1} = 1/\sqrt{\theta_{\rho k-1,\rho k-1} - \tilde{u}_{k-2}^{H}\tilde{u}_{k-2}}, \qquad \tilde{u}_{k-2} = (\bar{t}_{(\rho,:)}^{H})^{H},$$

$\theta_{\rho k-1,\rho k-1}$ est un élément dans une $\rho_{k-1}^{ième}$ ligne et une $\rho_{k-1}^{ième}$ colonne dans $\Theta$, $\bar{t}_{(\rho,:)}^{H}$ est une $(\rho_{k-1})^{ième}$ ligne dans $\overline{T}_{k-2}$, et $\rho_{k-1}$ est un numéro de séquence d'une colonne dans la matrice de détection, où la colonne est une colonne d'un (k-1)$^{ième}$ tableau le plus corrélé à la valeur mesurée du signal original dans la matrice de détection.

**3.** Procédé selon la revendication 2, dans lequel, avant l'étape de soustraire, de la corrélation entre la (k-1)$^{ième}$ erreur résiduelle et les colonnes multiples dans la matrice de détection, un produit d'une (k-1)$^{ième}$ différence de base et d'un (k-1)$^{ième}$ coefficient de différence pour obtenir la corrélation entre la k$^{ième}$ erreur résiduelle et les colonnes multiples dans la matrice de détection, la détermination d'une corrélation entre une k$^{ième}$ erreur résiduelle et les colonnes multiples dans la matrice de détection comprend en outre l'étape suivante :

déterminer un k$^{ième}$ coefficient de différence a$_k$ en utilisant la formule $a_k = \lambda_k q_{\rho k}^{k-1}$.

**4.** Procédé selon la revendication 2 ou la revendication 3, dans lequel le procédé comprend en outre les étapes suivantes :

déterminer F$_1$ en utilisant la formule $F_1 = [\lambda_1]$ ; et

$$F_k = \begin{bmatrix} F_{k-1} & u_{k-1} \\ 0_{k-1}^{T} & \lambda_k \end{bmatrix},$$

si $2 \le k \le K$, déterminer F$_k$ en utilisant la formule : où $u_{k-1} = -\lambda_k F_{k-1}\tilde{u}_{k-1}$ ; et
la récupération du signal original d'un signal reçu après avoir déterminé un K$^{ième}$ tableau de la matrice de base comprend l'étape suivante :
récupérer le signal en fonction de F$_K$.

**5.** Procédé selon la revendication 4, dans lequel : la récupération du signal en fonction de F$_K$ comprend les étapes suivantes :

déterminer un vecteur colonne de coefficient de pondération z$_K$ en utilisant la formule z$_K$ = F$_K$a$_K$ ;
déterminer x selon le vecteur colonne de coefficient de pondération pour obtenir $\hat{x}_{\tau_k} = z_k$, où z$_k$ est un k$^{ième}$ élément de z$_K$, et $\tau_k$ est une colonne dans un tableau le plus corrélé à la valeur mesurée du signal original dans la matrice de détection ; et
obtenir le signal original en fonction de x.

**6.** Procédé selon la revendication 1, dans lequel :
la détermination d'une première différence de base comprend l'étape suivante :

déterminer une première colonne et une deuxième colonne de $\overline{T}_2$ comme première différence de base ; et
la détermination de la (k-1)$^{ième}$ différence de base comprend l'étape suivante :
déterminer une (2k-3)$^{ième}$ colonne et une (2k-2)$^{ième}$ colonne de $\overline{T}_{2k-2}$ comme (k-1)$^{ième}$ différence de base, où :

$$\overline{T}_2 = \left[\lambda_1\theta_{(\rho 1)} \ f_{1,2}\theta_{(\rho 1)} + \lambda_2 \times flipud(\theta_{(\rho 1)}^{*})\right]$$

$$\overline{T}_{2k-2} = \left[\overline{T}_{2k-4} \ \lambda_{2k-3}\tilde{t}_k \left(f_{2k-3,2k-2}\tilde{t}_{k-1} + \lambda_{2k-2} \times flipud(\tilde{t}_{k-1}^{*})\right)\right]$$

$\lambda_1 = \sqrt{1/\theta_{\rho 1,\rho 1}}$, où $\theta_{\rho 1,\rho 1}$ représente un élément dans une $\rho_1^{ième}$ ligne et une $\rho_1^{ième}$ colonne dans la

matrice de détection $\Theta$, $\theta_{(\rho 1)}$ est la $\rho_1{}^{\text{ième}}$ colonne dans la matrice de détection $\Theta$, $f_{1,2} = -\lambda_2 \lambda_1 u_1^{''}$,

$$\lambda_2 = 1/\sqrt{\theta_{\rho 1,\rho 1} - \left(u_1^{''}\right)^* u_1^{''}}, \quad u_1^{''} = \lambda_1 \times {}_{\theta_{\rho 1,N-\rho 1+1}}, \; \theta_{\rho 1,N-\rho 1+1}$$ représente un élément dans la $\rho_1{}^{\text{ième}}$

ligne et une $(N - \rho_1 + 1)^{\text{ième}}$ colonne dans la matrice de détection $\Theta$, $q_{\rho 1}^H$ est la $\rho_1{}^{\text{ième}}$ ligne dans Q, Q est une matrice composée de corrélations entre la première erreur résiduelle et les colonnes multiples dans la matrice

de détection, $$\lambda_{2k-3} = 1/\sqrt{\theta_{\rho k-1,\rho k-1} - \tilde{u}_{2k-4}^{'H} \tilde{u}_{2k-4}^{'}}, \quad \tilde{u}_{2k-4}^{'} = (\overline{T}_{2k-4}(\overline{\rho}_{k-1},:))^H, \; \overline{T}_{2k-4}(\overline{\rho}_{k-1},:)$$ représen-

te une $(\overline{\rho}_{k-1})^{\text{ième}}$ ligne dans la matrice $\overline{T}_{2k-4}$, $f_{2k-3,2k-2} = -\lambda_{2k-2}\lambda_{2k-3}\tilde{u}_{2k-3}^{''}$,

$$\lambda_{2k-2} = 1/\sqrt{1/\lambda_{2k-3}^2 - \left|\tilde{u}_{2k-3}^{''}\right|^2}$$

$$\tilde{u}_{2k-3}^{''} = \lambda_{2k-3}\left(\theta_{\overline{\rho}k-1,\rho k-1} - \overline{T}_{2k-4}(\overline{\rho}_{k-1},:) \times \tilde{u}_{2k-4}^{'}\right)^*, \; \tilde{t}_{k-1} = \theta_{(\rho k-1)} - \overline{T}_{2k-4}\tilde{u}_{2k-4}^{'},$$ et $\theta_{(\rho k-1)}$ est une $\rho_{k-1}{}^{\text{ième}}$ colonne dans *la matrice* $\Theta$.

7.  Appareil de reconstruction de signal (600), comprenant :

    une première unité de détermination (610), configurée pour déterminer une corrélation entre une première erreur résiduelle et des colonnes multiples dans une matrice de détection selon une valeur mesurée d'un signal original et la matrice de détection, et déterminer un premier tableau le plus corrélé à la valeur mesurée du signal original dans la matrice de détection selon la corrélation entre la première erreur résiduelle et les colonnes multiples dans la matrice de détection, où la première erreur résiduelle est une valeur initiale d'une erreur résiduelle et est égale à un vecteur de valeur mesurée ;
    une deuxième unité de détermination (620), configurée pour déterminer une corrélation entre une k$^{\text{ième}}$ erreur résiduelle et les colonnes multiples de la matrice de détection en fonction d'une corrélation entre une $(k-1)^{\text{ième}}$ erreur résiduelle et les colonnes multiples dans la matrice de détection, et déterminer un k$^{\text{ième}}$ tableau le plus corrélé à la valeur mesurée du signal original dans la matrice de détection en fonction de la corrélation entre la k$^{\text{ième}}$ erreur résiduelle et les colonnes multiples dans la matrice de détection, où $2 \leq k \leq K$ ; et
    une unité de récupération (630), configurée pour récupérer le signal original après que la deuxième unité de détermination a déterminé un K$^{\text{ième}}$ tableau le plus corrélé à la valeur mesurée du signal original dans la matrice de détection ; **caractérisée en ce que** la deuxième unité de détermination est spécifiquement configurée pour :

    si k = 2, déterminer une première différence de base ;
    si k = 3, déterminer la $(k-1)^{\text{ième}}$ différence de base en fonction d'une première différence de base ; ou
    si $k \geq 4$, déterminer la $(k-1)^{\text{ième}}$ différence de base en fonction des première à $(k-2)^{\text{ième}}$ différences de base, la deuxième unité de détermination étant spécifiquement configurée pour déterminer la première différence de base $\overline{t}_{N-1}$ en utilisant la formule $\overline{t}_1 = \lambda_1 \cdot \theta_{(\rho 1)}$ ;
    où :

    $$\lambda_1 = \sqrt{1/\theta_{\rho 1,\rho 1}}, \; \theta_{(\rho 1)}$$ est une $\rho_1{}^{\text{ième}}$ colonne de $\Theta$, $\theta_{\rho 1,\rho 1}$ est un élément dans une $\rho_1{}^{\text{ième}}$ ligne et une $\rho_1{}^{\text{ième}}$ colonne dans $\Theta$, $\Theta$ est une matrice de corrélation de la matrice de détection, $\rho_1$ est un numéro de séquence d'une colonne dans la matrice de détection, où la colonne est une colonne d'un premier tableau le plus corrélé à la valeur mesurée du signal original dans la matrice de détection, $\overline{T}_1 = [\overline{t}_1]$.

8.  Appareil selon la revendication 7, dans lequel la deuxième unité de détermination est spécifiquement configurée pour :
    déterminer la $(k-1)^{\text{ième}}$ différence de base en utilisant la formule $\overline{t}_{k-1} = -\lambda_{k-1}\overline{T}_{k-2}\tilde{u}_{k-2} + \lambda_{k-1}\theta_{(\rho k-1)}$, où

$$\bar{T}_{k-2} = [\bar{T}_{k-3}\ \bar{t}_{k-2}],\ \lambda_{k-1} = 1/\sqrt{\theta_{\rho k-1,\rho k-1} - \tilde{u}_{k-2}^{H}\tilde{u}_{k-2}},\ \tilde{u}_{k-2} = (\bar{t}_{(\rho,:)}^{H})^{H},\ \theta_{\rho k-1,\rho k-1}$$

est un élément dans une $(\rho_{k-1})^{\text{ième}}$ ligne et une $(\rho_{k-1})^{\text{ième}}$ colonne dans $\Theta$, $\bar{t}_{(\rho,:)}^{H}$ est une $(\rho_{k-1})^{\text{ième}}$ ligne dans $\bar{T}_{k-2}$, et $\rho_{k-1}$ est un numéro de séquence d'une colonne dans la matrice de détection, où la colonne est une colonne d'un $(k-1)^{\text{ième}}$ tableau le plus corrélé à la valeur mesurée du signal original dans la matrice de détection.

**9.** Appareil selon la revendication 8, dans lequel la deuxième unité de détermination est en outre configurée pour :

déterminer le $k^{\text{ième}}$ coefficient de différence $a_k$ en utilisant la formule $a_k = \lambda_k q_{\rho k}^{k-1}$.

**10.** Appareil selon la revendication 8 ou la revendication 9, dans lequel l'appareil comprend en outre :
une troisième unité de détermination, configurée pour :

déterminer $F_1$ en utilisant la formule $F_1 = [\lambda_1]$ ; et si $2 \leq k \leq K$, déterminer $F_k$ en utilisant la formule

$F_k = \begin{bmatrix} F_{k-1} & u_{k-1} \\ 0_{k-1}^{T} & \lambda_k \end{bmatrix}$, où $u_{k-1} = -\lambda_k F_{k-1}\tilde{u}_{k-1}$ ; et

l'unité de récupération est spécifiquement configurée pour récupérer le signal en fonction de $F_K$.

**11.** Appareil selon la revendication 10, dans lequel l'unité de récupération est spécifiquement configurée pour :

déterminer un vecteur colonne de coefficient de pondération $z_K$ en utilisant la formule $z_K = F_K a_K$ ;
déterminer $x$ selon le vecteur colonne de coefficient de pondération pour obtenir $\hat{x}_{\tau_k} = z_k$, où $z_k$ est un $k^{\text{ième}}$ élément de $z_K$, et $\tau_k$ est une colonne dans un tableau le plus corrélé à la valeur mesurée du signal original dans la matrice de détection ; et
obtenir le signal original en fonction de $x$.

<u>100</u>

Determine a correlation between a first residual error and multiple columns in a sensing matrix according to a measured value of an original signal and the sensing matrix, and determine a first array most correlative to the measured value of the original signal in the sensing matrix according to the correlation between the first residual error and the multiple columns in the sensing matrix

S110

Determine a correlation between a $k^{th}$ residual error and the multiple columns in the sensing matrix according to a correlation between a $(k-1)^{th}$ residual error and the multiple columns in the sensing matrix, and determine a $k^{th}$ array most correlative to the measured value of the original signal in the sensing matrix according to the correlation between the $k^{th}$ residual error and the multiple columns in the sensing matrix, where $2 \leq k \leq K$

S120

Recover the original signal after determining the $K^{th}$ array most correlative to the measured value of the original signal in the sensing matrix

S130

FIG. 1

<u>200</u>

| | |
|---|---|
| Collect a measured value of an original signal | S201 |

↓

| | |
|---|---|
| After the measured value of the original signal is obtained, store or transmit the measured value | S202 |

↓

| | |
|---|---|
| Determine the original signal to be reconstructed, and perform an initialization process | S203 |

↓

| | |
|---|---|
| Determine a first column most correlative to the measured value of the original signal in the sensing matrix | S204 |

↓

| | |
|---|---|
| Determine intermediate values $\bar{t}_{N-1}, \bar{T}_1, a_1, \mathbf{a}_1$, and $\mathbf{F}_1$ for subsequent iteration or subsequent signal recovery, and update related variables | S205 |

↓

| | |
|---|---|
| Determine a $k^{th}$ column most correlative to the measured value of the original signal in the sensing matrix | S206 |

↓

| | |
|---|---|
| Determine intermediate values $\mathbf{t}_{\square^-(k)}, a_k, \bar{T}_k, \mathbf{a}_k$, and $\mathbf{F}_k$ for subsequent iteration, and update related matrices | S207 |

k<K-1                                               k=K-1

↓ k=K

| | |
|---|---|
| Recover the original signal | S208 |

FIG. 2

300

| | |
|---|---|
| Collect a measured value of an original signal | S301 |

↓

| | |
|---|---|
| After the measured value of the original signal is obtained, store or transmit the measured value | S302 |

↓

| | |
|---|---|
| Determine the original signal to be reconstructed, and perform an initialization process | S303 |

↓

| | |
|---|---|
| Determine a first column most correlative to the measured value of the original signal in the sensing matrix | S304 |

↓

| | |
|---|---|
| Determine intermediate values $\overline{t}_1$, $\overline{T}_1$, $\alpha_1$, $a_1$, and $F_1$ for subsequent iteration or subsequent signal recovery, and update related variables | S305 |

↓

| | |
|---|---|
| Determine a $k^{th}$ column most correlative to the measured value of the original signal in the sensing matrix | S306 |

↓

| | |
|---|---|
| Determine intermediate values $\overline{t}_k$, $\alpha_k$, $\overline{T}_k$, $a_k$, and $F_k$ for subsequent iteration, and update related matrices | S 307 |

k<K-1                    k=K-1

↓ k=K

| | |
|---|---|
| Recover the original signal | S308 |

FIG. 3

$\overline{400}$

| S401 |
|---|
| Obtain a measured value of an original signal and a corresponding dictionary |

| S402 |
|---|
| After the measured value of the original signal is obtained, store or transmit the measured value |

| S403 |
|---|
| Determine the original signal to be reconstructed, and perform an initialization process |

| S404 |
|---|
| Determine a first array most correlative to the measured value of the original signal in the sensing matrix |

| S405 |
|---|
| Determine intermediate values $F_2$, $A_2$, and $\overline{T}_{N-2}$ for subsequent iteration or subsequent signal recovery, and update related variables |

| S406 |
|---|
| Determine a $k^{th}$ array most correlative to the measured value of the original signal in the sensing matrix |

| S407 |
|---|
| Determine intermediate values $F_{2k}$, $A_{2k}$, and $\overline{T}_{\square^-,(2k)}$ for subsequent iteration, and update related matrices |

$k < K - 1$

$k = K-1$

$k = K$

| S408 |
|---|
| Recover the original signal according to the index of the selected atom of the base matrix |

FIG. 4

$\overline{500}$

Obtain a measured value of an original signal and a corresponding dictionary /S501

↓

After the measured value of the original signal is obtained, store or transmit the measured value /S502

↓

Determine the original signal to be reconstructed, and perform an initialization process /S503

↓

Determine a first array most correlative to the measured value of the original signal in the sensing matrix /S504

↓

Determine intermediate values $F_2$, $A_2$, and $\overline{T}_2$ for subsequent iteration or subsequent signal recovery, and update related variables /S505

↓

Determine a $k^{th}$ array most correlative to the measured value of the original signal in the sensing matrix /S506

↓

Determine intermediate values $F_{2k}$, $A_{2k}$, and $\overline{T}_{2k}$ for subsequent iteration, and update related matrices /S507

k<K-1                                          k=K-1

↓ k=K

Recover the original signal according to the index of the selected atom of the base matrix /S508

FIG. 5

FIG. 6

FIG. 7

FIG. 8

700

Memory 710

Processor 720

FIG. 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **T. TONY CAI et al.** Orthogonal Matching Pursuit for Sparse Signal Recovery with Noise. *IEEE TRANSACTIONS ON INFORMATION THEORY,* 01 July 2011, vol. 57 (7), 4680-4688
- **GAO RUI et al.** Variable Step Size Adaptive Matching Pursuit Algorithm for Image Reconstruction Based on Compressive Sensing. *GUANXUE XUEBAO - ACTA OPTICA SINICA, SHANGHAI KEXUE JISHU CHUBANSHE,* 01 June 2010, vol. 30 (6), 1639-1644
- From Theory to Practice: Sub-Nyquist Sampling of Sparse Wideband Analog Signals. *IEEE JOURNAL OF SELECTED TOPICS IN SIGNAL PROCESSING,* April 2010, vol. 4 (2